# FASCICULE DE BREVET EUROPEEN

(11) **EP 3 320 353 B1**
(45) Date de publication et mention de la délivrance du brevet: **13.04.2022**
(21) Numéro de dépôt: 16744810.9
(22) Date de dépôt: 08.07.2016
(51) Int. Cl.: G01R 31/28

(54) **DISPOSITIF DESTINÉ À FONCTIONNER DANS UN ENVIRONNEMENT HOSTILE**
ZUM BETRIEB IN EINER FEINDSELIGEN UMGEBUNG BESTIMMTE VORRICHTUNG
DEVICE INTENDED FOR OPERATING IN A HOSTILE ENVIRONMENT

(30) Priorité: 09.07.2015 FR 1556504
(43) Date de publication de la demande: 16.05.2018
(73) Titulaire: Elements, 31100 Toulouse (FR)
(72) Inventeur: LAVIELLE, Denis, 31130 Balma (FR); MESNIER, Didier, 31400 Toulouse (FR); GALINIER, Stéphane, 31370 Rieumes (FR); BALLOT, Yohann, 31570 SAINT PIERRE DE LAGES (FR)
(74) Mandataire: Ipside
(86) Numéro de dépôt international: PCT/FR2016/051753
(87) Numéro de publication internationale: WO 2017/006070

(56) Documents cités:
- US-A1- 2006 002 161
- US-A1- 2007 208 538
- US-A1- 2014 152 338

## Description

### DOMAINE TECHNIQUE

La présente invention appartient au domaine de la détection de défaillances d'un dispositif électronique complexe ainsi que de la prolongation de la durée de vie dudit dispositif. Elle concerne plus particulièrement un dispositif destiné à fonctionner en environnement hostile ainsi qu'un procédé de mise en oeuvre d'un tel dispositif. L'invention trouve une application particulièrement avantageuse, bien que nullement limitative, dans le cas de robots de démantèlement nucléaire équipés de tels dispositifs.

### ÉTAT DE LA TECHNIQUE

Actuellement, il existe différents modes de réalisation et de mise en oeuvre d'un dispositif électronique comportant des composants électroniques et destinés à fonctionner dans un environnement hostile, c'est-à-dire un environnement altérant la durée de vie dudit dispositif.

C'est notamment le cas pour des applications industrielles ou militaires concernant le domaine spatial (vols spatiaux ou en haute altitude) ainsi que le domaine nucléaire. Dans ces types d'environnements, l'utilisation de composants électroniques se révèle problématique dans la mesure où ces derniers sont soumis à des conditions extrêmes, notamment de température mais aussi et surtout de rayonnements ionisants. Ces derniers, plus particulièrement, sont source de perturbations fonctionnelles qui peuvent être soit de nature passagères (mais pouvant néanmoins conduire à des dysfonctionnements prolongés), soit de nature permanentes. Ainsi, de telles perturbations, et ce d'autant plus lorsqu'elles sont associées à une exposition prolongée aux radiations, sont finalement susceptibles de mener à des dommages irréversibles des composants, comme par exemple leurs destructions fonctionnelles ou bien encore leurs verrouillages fonctionnels dans des configurations non souhaitées, voire aussi leurs altérations physiques.

Il est connu que pour remédier à ces inconvénients, à savoir notamment assurer une tenue prolongée et fonctionnelle face aux radiations, des solutions dites de « durcissement électronique » peuvent être mises en oeuvre. A cet effet, le durcissement peut consister à développer des dispositifs électroniques selon des cahiers de charges très précis, cela étant tout particulièrement le cas pour des applications du domaine spatial. Toutefois, le caractère non générique d'une telle solution implique des coûts de développement et d'exploitation très élevés, si bien qu'elle ne peut être étendue à d'autres domaines applicatifs. Une seconde solution, notamment exploitée dans le domaine nucléaire, consiste dès lors à développer ces dispositifs électroniques à partir de composants génériques, c'est-à-dire non dédiés spécifiquement à un cahier des charges précis, tout en renforçant les capacités de ces dispositifs à fonctionner correctement ainsi que durablement.

De manière conventionnelle, que ce soit au moyen de composants dédiés ou bien génériques, la mise en oeuvre du durcissement d'un dispositif électronique se décline selon deux types de méthodes, éventuellement conjuguées l'une de l'autre. Une première méthode consiste en des techniques de durcissement matériel, dans lesquelles, par exemple, le dispositif électronique est muni d'un blindage afin de le protéger des rayonnements et donc lui permettre d'accroître sa durée de fonctionnement. Cela étant, un inconvénient majeur d'une telle méthode est qu'elle augmente nettement le poids embarqué du dispositif.

Une deuxième méthode relève quant à elle de techniques de durcissement logique des composants électroniques du dispositif. Il s'agit notamment de dupliquer certains composants électroniques remplissant une fonction électronique similaire, ces composants étant programmés de sorte à détecter une défaillance de ladite fonction électronique, et éventuellement garantir la réalisation effective de ladite fonction électronique. Toutefois, cette méthode présente le désavantage de ne pas permettre une prolongation de la durée de vie du dispositif puisque tous lesdits composants fonctionnent en même temps (on parle dès lors de « redondance chaude ») si bien que leurs durées de vie respectives décroissent de manière simultanée. Les documents US 2014/152338 et US 2006/002161 divulguent un état de la technique pertinent.

### EXPOSÉ DE L'INVENTION

La présente invention a pour objectif de remédier à tout ou partie des inconvénients de l'art antérieur, notamment ceux exposés ci-avant, en proposant une solution qui permette d'avoir des dispositifs destinés à fonctionner en environnement hostile, sans nécessiter de protections matérielles additionnelles augmentant le poids desdits dispositifs, et en outre adaptée à prolonger la durée de vie desdits dispositifs malgré l'altération de leurs intégrités respectives du fait d'être placés dans ledit environnement hostile.

A cet effet, et selon un premier aspect, il est proposé par la présente invention, un dispositif destiné à fonctionner dans un environnement hostile affectant son intégrité de fonctionnement, ledit dispositif comportant un premier module électronique, dit module de fonction, comprenant au moins un premier appareil électronique adapté à fournir une fonction audit module de fonction. En outre, ledit module de fonction comporte au moins un deuxième appareil électronique adapté à fournir au dispositif la même fonction que le premier appareil électronique, ce deuxième appareil électronique n'étant pas alimenté en énergie tant que le premier appareil électronique est alimenté, et ledit dispositif comporte également :
- des moyens de mesure itérative d'au moins un paramètre de fonctionnement du dispositif,
- des moyens de contrôle de l'intégrité du dispositif par comparaison d'une valeur calculée sur la base de ce au moins un paramètre avec au moins une valeur seuil prédéterminée,
- des moyens de commutation électrique adaptés à mettre le deuxième appareil électronique en fonctionnement et d'arrêter le fonctionnement du premier appareil électronique si la valeur calculée est supérieure à la valeur seuil prédéterminée

Dans des modes particuliers de réalisation, le dispositif destiné à fonctionner dans un environnement hostile peut comporter en outre l'une ou plusieurs des caractéristiques suivantes, prises isolément ou selon toutes les combinaisons techniquement possibles.

Dans un mode particulier de réalisation les appareils électroniques du module de fonction sont respectivement adaptés à émettre/recevoir des signaux sur un réseau de communication filaire, et en ce que :
- lesdits moyens de mesure comportent au moins une carte électronique de mesure adaptée à fournir et émettre ledit au moins un paramètre sur un réseau de communication électrique,
- lesdits moyens de contrôle comportent un module de contrôle comportant un microcontrôleur adapté à analyser l'intégrité du dispositif par comparaison dudit au moins un paramètre fourni par ladite au moins une carte de mesure avec au moins une valeur seuil prédéterminée,
- les moyens de commutation électrique sont intégrés au module de contrôle et sont adaptés à activer électriquement lesdits appareils électroniques, le microcontrôleur étant en outre configuré pour qu'un seul appareil électronique fonctionne à la fois en fonction de l'analyse d'intégrité exécutée par ledit microcontrôleur,
- le dispositif comporte un module d'alimentation destiné à être connecté à une source d'énergie et adapté à fournir l'énergie nécessaire au fonctionnement des modules respectivement de fonction et de contrôle,
- le dispositif comporte une carte de support adaptée à acheminer les signaux échangés sur les réseaux de communication respectivement filaire et électrique, ainsi que l'énergie fournie par ledit module d'alimentation.

Dans un mode particulier de réalisation les modules de contrôle et de fonction comportent chacun une borne de connexion au réseau de communication filaire, le module de fonction comportant un premier commutateur réseau et au moins un deuxième commutateur réseau, chacun desdits commutateurs réseau étant adapté à relier les appareils électroniques du module de fonction auxdites bornes de connexion, et en ce que les moyens de commutation électrique du module de contrôle sont en outre adaptés à activer électriquement lesdits commutateurs réseau, le module de contrôle étant en outre configuré pour qu'un seul commutateur réseau fonctionne à la fois en fonction de l'analyse d'intégrité exécutée par ledit module de contrôle.

Dans un mode particulier de réalisation, lesdits moyens de commutation électrique comportent des relais électromécaniques bistables respectivement reliés soit à un appareil électronique, soit à un commutateur réseau, du module de fonction.

Dans un mode particulier de réalisation, le dispositif comporte une carte de mesure intégrée au module de fonction.

Dans un mode particulier de réalisation, le dispositif comporte une carte de mesure intégrée au module de contrôle.

Dans un mode particulier de réalisation, le dispositif comporte une carte de mesure intégrée au module d'alimentation.

Dans un mode particulier de réalisation, ledit au moins un paramètre fourni par une carte de mesure d'un module est représentatif d'un signal de tension électrique alimentant ledit module, et en ce que ladite au moins une valeur seuil prédéterminée comprend une valeur de tension électrique associée audit module.

Dans un mode particulier de réalisation, ledit au moins un paramètre fourni par une carte de mesure d'un module est représentatif d'un signal de courant électrique alimentant ledit module, et en ce que ladite au moins une valeur seuil prédéterminée comprend une valeur de courant électrique associée audit module.

Dans un mode particulier de réalisation, ledit au moins un paramètre fourni par une carte de mesure d'un module est représentatif d'un signal de température dudit module, et en ce que ladite au moins une valeur seuil prédéterminée comprend une valeur de température associée audit module.

Dans un mode particulier de réalisation, ledit au moins un paramètre fourni par une carte de mesure d'un module est représentatif d'un signal de dose instantanée de rayonnements ionisants subie par ledit module et/ou un signal de dose cumulée de rayonnements ionisants subie par ledit module, et en ce que ladite au moins une valeur seuil prédéterminée comprend une valeur de dose instantanée et/ou une valeur de dose cumulée respectivement associées audit module.

Dans un mode particulier de réalisation, ledit au moins un signal fourni par une carte de mesure d'un module est mesuré périodiquement suivant une période prédéterminée, de préférence une période sensiblement égale à 1 seconde.

Dans un mode particulier de réalisation, le module de contrôle est adapté à détecter une coupure d'alimentation dudit dispositif, et comporte des moyens de mémorisation adaptés à sauvegarder la configuration électronique dudit dispositif lors de l'activation d'un desdits appareils électroniques du module de fonction et/ou lors d'une coupure d'alimentation dudit dispositif.

Dans un mode particulier de réalisation, lesdits moyens de mémorisation comportent une puce électronique de type EEPROM.

Dans un mode particulier de réalisation, le module d'alimentation comporte des régulateurs de tension adaptés à fournir des tensions électriques d'alimentation régulées respectivement au module de contrôle et au module de fonction.

Dans un mode particulier de réalisation, la source d'énergie du module d'alimentation est externe audit dispositif, et délivre une tension électrique alternative ou bien une tension électrique continue.

Dans un mode particulier de réalisation, la source d'énergie du module d'alimentation comprend une batterie électrique intégrée audit dispositif et délivrant une tension électrique continue.

Dans un mode particulier de réalisation, la fonction fournie par les appareils électroniques du module de fonction est une fonction de communication sur un réseau de communication sans fil selon un protocole prédéterminé, chaque appareil électronique comportant une carte de communication adaptée à acheminer des signaux selon ledit protocole ainsi qu'une antenne omnidirectionnelle ou bien encore directive selon l'utilisation à laquelle est destinée le dispositif.

Selon un deuxième aspect, l'invention concerne un système destiné à fonctionner dans un environnement hostile comportant :
- un premier dispositif selon l'invention, destiné à être connecté au moyen de la borne de connexion de son module de fonction à un appareil mobile, par exemple un robot de démantèlement nucléaire, équipé dudit premier dispositif,
- un second dispositif selon l'invention, destiné à être connecté au moyen de la borne de connexion de son module de fonction à un terminal distant installé en dehors de l'environnement hostile,
- un ensemble de moyens configurés de façon logicielle pour configurer et commander de manière forcée les fonctionnements respectifs desdits premier et deuxième dispositifs, ainsi que pour contrôler de manière itérative l'intégrité desdits premier et deuxième dispositifs, et destinés en outre à commander de manière forcée les déplacements dudit appareil mobile.

Dans un mode particulier de réalisation, ledit ensemble de moyens configurés de façon logicielle du système est un produit programme d'ordinateur comportant un ensemble d'instructions de code de programme destinées à être exécutées par ledit terminal distant, de préférence un ordinateur PC fixe comportant au moins un processeur.

Selon un troisième aspect, l'invention concerne un procédé de prolongation de la durée de vie d'une fonction d'un dispositif selon l'invention, ledit procédé comportant une étape préalable de caractérisation de l'intégrité dudit dispositif de sorte à obtenir ladite au moins une valeur seuil, ledit dispositif étant désactivé à l'issue de ladite étape préalable. En outre, ledit procédé comporte les étapes successives suivantes :
- une étape d'initialisation du dispositif dans laquelle est défini le routage des commutateurs réseau dudit dispositif,
- une étape de démarrage du dispositif dans laquelle un seul appareil électronique est activé, les autres appareils électroniques restant désactivés,
- une étape de mesure d'au moins un paramètre de fonctionnement de l'appareil électronique activé,
- une étape d'analyse d'intégrité du dispositif dans laquelle, lorsque l'intégrité du module de fonction dudit dispositif est altérée, l'appareil électronique activé est désactivé définitivement, et un seul desdits autres appareils électroniques désactivés est activé,
- une étape d'évaluation d'une durée de vie restante du dispositif par le module de contrôle dudit dispositif,
les étapes de mesure, d'analyse d'intégrité et d'évaluation de la durée de vie étant exécutées de manière itérative jusqu'à ce que la durée de vie restante d'un appareil électronique précédemment activé puis désactivé soit restaurée, ou que la durée de vie restante du dispositif soit épuisée.

Dans un mode alternatif de mise en oeuvre, lorsque l'intégrité du module de fonction du dispositif est altérée, l'appareil électronique activé reste activé au cours de l'étape d'analyse d'intégrité, les autres appareils électroniques jusqu'alors désactivés restant désactivés, de sorte à maintenir de manière forcée la fonction du module de fonction.

### PRÉSENTATION DES FIGURES

Les caractéristiques et avantages de l'invention seront mieux appréciés grâce à la description qui suit, description qui expose les caractéristiques de l'invention au travers de modes de mise en oeuvre préférés, qui n'en sont nullement limitatifs.

La description s'appuie sur les figures annexées qui représentent :
- Figure 1 : une représentation schématique d'un exemple de réalisation d'un dispositif destiné à fonctionner en environnement hostile.
- Figure 2 : une représentation schématique d'un mode préféré de réalisation d'un système destiné à fonctionner dans un environnement radiatif, et comportant un premier dispositif et un deuxième dispositif respectivement de la figure 1.
- Figure 3 : une représentation d'un organigramme d'un exemple de mise en oeuvre d'un procédé de prolongation de la durée de vie d'une fonction d'un dispositif de la figure 1.
- Figure 4 : une représentation schématique d'un exemple de réalisation d'un dispositif de surveillance et/ou de détection de défaillance.
- Figure 5 : une représentation schématique d'un exemple de mise en oeuvre d'un dispositif de la figure 4.

Dans ces figures, des références identiques d'une figure à une autre désignent des éléments identiques ou analogues. Pour des raisons de clarté, les éléments représentés ne sont pas à l'échelle, sauf mention contraire.

### DESCRIPTION DÉTAILLÉE DE MODES DE RÉALISATION

La présente invention trouve sa place dans le domaine des interventions industrielles en environnement hostile, lesdites interventions étant pilotées/commandées/contrôlées à distance par exemple par un opérateur.

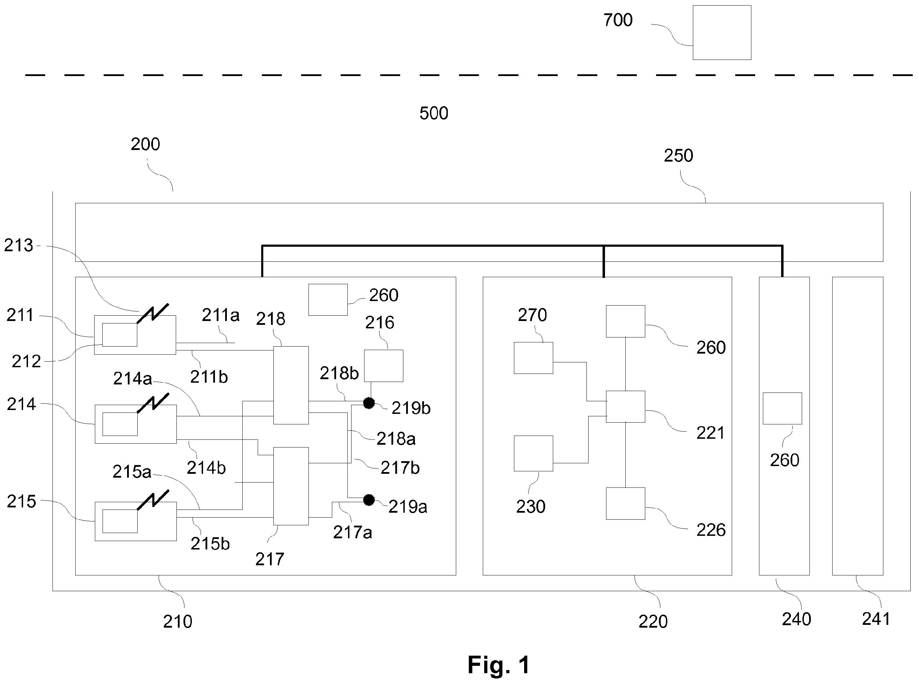

La figure 1 représente schématiquement un exemple de réalisation d'un dispositif 200 destiné à fonctionner dans un environnement hostile 500.

Par « environnement hostile » 500, on entend ici un environnement imposant audit dispositif 200 une ou plusieurs contraintes affectant son fonctionnement de sorte à réduire sa durée de vie nominale, cette dernière étant définie comme étant la durée pendant laquelle ledit dispositif est en mesure d'assurer une fonction pour laquelle il est réalisé et mis en oeuvre lorsqu'il est placé dans un environnement sans contraintes.

A cet effet, les contraintes imposées par un environnement hostile 500 peuvent, d'une part, survenir de manière intermittente, comme par exemple dans le cas d'un dispositif 200 réalisant une fonction de détection d'obstacles et équipant un robot destiné à évoluer de manière autonome au sein d'un environnement 500 comportant des obstacles (murs, trous, etc.). D'autre part, les contraintes peuvent être imposées de manière continue, comme par exemple dans le cas d'un dispositif 200 placé dans un environnement 500 où la température est suffisamment élevée pour affecter son intégrité et réduire graduellement dans le temps sa durée de vie. Il convient de noter que les contraintes imposées de manière continue ont, d'une manière générale, pour origine une source énergétique distante dudit dispositif 200.

La suite de la description vise plus spécifiquement, mais de manière non limitative, un dispositif 200 destiné à fonctionner dans un environnement radiatif 500, c'est-à-dire soumis à des rayonnements ionisants, comme par exemple une centrale nucléaire ou un laboratoire de recherche, éventuellement en cours de démantèlement. Rien n'exclut cependant, suivant d'autres exemples non détaillés ici, d'avoir un dispositif 200 destiné à fonctionner dans un autre environnement hostile 500, comme par exemple dans l'espace, sous des températures extrêmes, dans un champ électromagnétique intense, etc.

Le dispositif 200 comporte un premier module électronique, dit module de fonction 210, comprenant au moins un premier appareil électronique 211 adapté à fournir une fonction audit module de fonction 210. Par « fonction », on fait référence ici à une tâche que le dispositif 200 est destiné à accomplir au sein de l'environnement hostile 500, cette tâche étant mise en oeuvre au moyen d'une pluralité de composants électroniques tels que décrits ci-après et appartenant non exclusivement audit module de fonction 210. Ces composants électroniques sont supportés de manière connue en soi par au moins une carte PCB (acronyme de l'expression anglaise « Printed Circuit Board »), pourvue de pistes conductrices formant au moins un circuit imprimé, lesdites pistes conductrices étant adaptées à acheminer des signaux électriques, réalisées par exemple en cuivre et séparées par un polymère époxyde. On note par ailleurs qu'en dehors de ladite au moins une carte de mesure décrite ci-après, l'ensemble des composants électroniques compris dans le dispositif 200 sont des composants dits « COTS » (acronyme de l'expression anglaise « commercial off-the-shelf »), c'est-à-dire des composants électroniques fabriqués en série.

La suite de la description vise plus spécifiquement, mais de manière non limitative, un dispositif 200 de communication. A cet effet, dans le présent exemple de réalisation, ledit premier appareil électronique 211 est un appareil électronique de communication, c'est-à-dire adapté à fournir une fonction de communication sur un réseau de communication sans fil selon un protocole prédéterminé. Ledit premier appareil de communication 211 comporte une carte de communication 212 connue en soi, et adaptée à émettre/recevoir des signaux, vers/depuis un terminal distant 700, selon ledit protocole ainsi qu'une antenne omnidirectionnelle 213. Par exemple, ledit protocole est un protocole de type Wifi^{®} selon l'une quelconque des normes 802.11 b/g/n.

Rien n'exclut cependant d'avoir une carte de communication 212 acheminant des signaux suivant un autre protocole comme par exemple BIuetooth^{®}, ZigBee^{®}, etc, ainsi qu'une antenne éventuellement directive 213. En outre, et de manière plus générale, rien n'exclut que ledit premier appareil électronique 211 fournisse une fonction autre qu'une fonction de communication, comme par exemple une fonction de localisation au sein d'un local fermé/dans un environnement ouvert, une fonction de détection de collision lorsque le dispositif 200 est destiné à équiper un appareil mobile ayant pour mission de se déplacer dans un environnement comportant des obstacles, etc.

Dès lors, le premier module électronique 210 est désormais dit module de communication 210. Ce module de communication 210 comporte au moins un deuxième appareil de communication 214 adapté à fournir au dispositif 200 la même fonction de communication que le premier appareil de communication 211, ce deuxième appareil de communication 214 n'étant pas alimenté en énergie tant que le premier appareil de communication 211 est alimenté. De telles dispositions permettent avantageusement d'assurer une continuité dans le temps de la fonction de communication du module de communication 210, et donc du dispositif 200, lorsque par exemple le premier appareil de communication 211 voit son intégrité altérée du fait qu'il est placé dans ledit environnement hostile 500. Autrement dit, ledit au moins deuxième appareil de communication 214 représente une redondance électronique dudit premier appareil de communication 211, redondance notamment qualifiée de « froide » dans la mesure où ledit au moins deuxième appareil 214 est mis dans une situation d'attente de fonctionnement tant que le premier appareil de communication 211 fonctionne. La manière dont le premier appareil 211 est mis à l'arrêt et ledit au moins deuxième appareil 214 mis en état de marche est détaillée ci-après.

D'une manière générale, les inventeurs ont par ailleurs constaté que, si l'ensemble du dispositif 200 est affecté par le stress imposé par l'environnement hostile 500, les composants électroniques polarisés le sont davantage, à savoir que leurs durées de vie respectives décroissent beaucoup plus rapidement que les durées de vies de composants non polarisés. Cela est tout particulièrement le cas dans un environnement radiatif 500. Ainsi, eu égard aux fonctionnements alternatifs respectivement du premier appareil de communication 211 et dudit au moins deuxième appareil de communication 214, on comprend que l'appareil de communication effectivement en marche voit sa durée de vie et son intégrité s'altérer plus vite.

Dans un mode particulier de réalisation, illustré par la figure 1 à titre nullement limitatif, le module de communication 210 comporte un deuxième appareil de communication 214 ainsi qu'un troisième appareil de communication 215. Lesdits deuxième 214 et troisième 215 appareils de communication fournissent la même fonction que le premier appareil de communication. En outre, tous les appareils de communication sont configurés de sorte qu'un seul d'entre eux fonctionne à la fois. Un tel nombre d'appareils de communication permet avantageusement de prolonger la durée de vie du dispositif 200, lorsque celui-ci est placé dans l'environnement hostile 500, tout en maintenant lesdits appareils de communication dans un volume limité de sorte qu'il est possible d'équiper facilement tout autre appareil, comme par un exemple un robot mobile, dudit dispositif 200 de communication. Rien n'exclut cependant, selon d'autres exemples non détaillés ici, d'avoir un dispositif 200 de communication comportant un nombre d'appareils de communication supérieur à 3. A cet effet, aucune limitation en nombre n'est imposée, ledit nombre dépendant principalement du temps total de fonctionnement souhaité du dispositif 200 dans ledit environnement hostile 500.

Le dispositif 200 comporte également des moyens de mesure d'au moins un paramètre de fonctionnement du dispositif 200, ainsi que des moyens de contrôle de l'intégrité du dispositif 200 par comparaison d'une valeur calculée sur la base de ce au moins un paramètre avec au moins une valeur seuil prédéterminée. Ladite valeur seuil prédéterminée est typiquement obtenue avant exploitation et mise en marche du dispositif 200, par exemple au cours d'une campagne préalable de caractérisation et de tests destinée à déterminer la résistance au stress imposé par l'environnement hostile 500.

Le fonctionnement du dispositif 200 s'entend ici comme le fonctionnement de toute l'électronique qu'il embarque. Ledit au moins un paramètre est donc une grandeur physique qui admet une représentation analogique sous forme d'un signal continu dans le temps. En outre, on note que par « valeur calculée sur la base de ce au moins un paramètre », on entend ici soit une valeur numérique exprimée dans la même unité physique qu'un paramètre (Volt, Ampère, degré Celsius, Gray, etc.), voire éventuellement de la combinaison algébrique de plusieurs paramètres tous associés à un même type de grandeur physique, soit encore une valeur booléenne qui est le résultat d'une expression mixte mathématique, comme par exemple un critère de décision, combinant un ou plusieurs paramètres associés respectivement à des grandeurs physiques éventuellement différentes.

Dans un mode particulier de réalisation, les appareils de communication du module de communication 210 sont respectivement adaptés à émettre/recevoir des signaux sur un réseau de communication filaire. Par exemple, ledit réseau de communication filaire est un réseau filaire Ethernet^{®}. Rien n'exclut cependant, suivants d'autres exemples non détaillés ici, d'avoir d'autres réseaux de communication filaire.

Lesdits moyens de contrôle comportent un module de contrôle 220 comportant un microcontrôleur 221 adapté à analyser l'intégrité du dispositif par comparaison dudit au moins un paramètre fourni par au moins une carte de mesure, décrite ci-après, avec au moins une valeur seuil prédéterminée, ainsi que par l'émission/réception de signaux du module de communication 220 sur ledit réseau de communication sans fil. Par exemple, un protocole de tests permettant de valider que les appareils de communication fonctionnent correctement relativement à l'émission/réception de signaux sur ledit réseau de communication sans fil, et à destination d'un terminal distant 700, est mis en oeuvre, ledit protocole de tests ayant été établi au préalable par un utilisateur du dispositif 200. La perte de communication entre le dispositif 200 et ledit terminal distant 700 est alors détectable, le dispositif 200 étant dès lors configuré pour arrêter le fonctionnement de l'appareil de communication détecté comme défectueux, puis à mettre en fonctionnement un autre appareil de communication.

Préférentiellement, le module de contrôle 220 est une carte électronique programmable adaptée à fonctionner dans un milieu radiatif jusqu'à une dose cumulée de 2000 Gy (Gray). Plus spécifiquement, le microcontrôleur 221 de ladite carte électronique programmable comporte par exemple un processeur de type ARM. Rien n'exclut cependant, suivant d'autres exemples non détaillés ici, d'avoir un module de contrôle 220 différent. En outre, le dispositif 200 est avantageusement configuré de sorte à fonctionner dans un milieu radiatif 500 jusqu'à une dose cumulée limite de 1000 Gy (Gray).

Dans un mode particulier de réalisation, les modules de contrôle 220 et de communication 210 comportent chacun une borne de connexion 216, 226 au réseau de communication filaire, le module de communication 210 comportant un premier commutateur réseau 217 et au moins un deuxième commutateur réseau 218, chacun desdits commutateurs réseau étant adapté à relier les appareils de communication du module de communication 210 auxdites bornes de connexion. Par ailleurs, ce deuxième commutateur réseau 218 n'est pas alimenté en énergie tant que le premier commutateur réseau 217 est alimenté.

Ainsi, les commutateurs réseau sont avantageusement configurés de sorte à permettre l'acheminement de signaux entre le dispositif 200, plus particulièrement son module de contrôle 220, et un terminal distant 700, ledit terminal distant 700 pouvant être lui-même raccordé audit réseau de communication filaire et/ou aussi adapté à émettre des signaux sur le réseau de communication sans fil. Par exemple, ledit terminal distant 700 peut être un ordinateur PC fixe, une tablette, etc. ou bien encore un second dispositif de communication selon l'invention.

Par ailleurs, on comprend qu'une telle configuration des commutateurs réseaux, en nombre et en raccordement, permet avantageusement, selon un principe identique de redondance froide décrit ci-avant relativement aux appareils de communication, d'assurer une continuité dans le temps de la fonction de communication du module de communication 210, et donc du dispositif 200, lorsque par exemple le premier commutateur réseau 217 voit son intégrité altérée du fait qu'il est placé dans ledit environnement hostile 500. Ainsi, le fait que le dispositif 200 comprend une pluralité de commutateurs réseaux assure une protection additionnelle de maintien de la fonction communication du dispositif 200.

Dans l'exemple illustré par la figure 1 à titre nullement limitatif, le module de communication 210 comporte un commutateur réseau principal 217 et un commutateur réseau auxiliaire 218, lesdits commutateurs réseau étant adaptés à l'acheminement de signaux selon le protocole Ethernet^{®} et configurés de sorte que :
- chaque carte de communication est reliée auxdits commutateurs réseau principal 217 et auxiliaire 218 par deux liaisons respectives 211a, 211b, 214a, 214b, 215a, 215b,
- les commutateurs réseau principal 217 et auxiliaire 218 sont reliés à un premier connecteur en Y 219a par deux liaisons respectives 217a, 218 a, ledit premier connecteur en Y 219a étant relié à la borne de connexion 226 du module de contrôle 220,
- les commutateurs réseau principal 217 et auxiliaire 218 sont reliés à un deuxième connecteur en Y 219b par deux liaisons respectives 217b, 218b, ledit deuxième connecteur en Y 219b étant relié à la borne de connexion 216 du module de communication 210.

Dans le présent exemple de réalisation, les liaisons reliant respectivement les cartes de communication aux commutateurs réseau, les connecteurs en Y aux commutateurs réseau, ainsi que les connecteurs en Y aux bornes de connexion, sont des câbles Ethernet^{®} de type RJ45.

Rien n'exclut cependant, selon d'autres exemples non détaillés ici, d'avoir un module de communication 210 comportant un nombre de commutateurs réseau supérieur à 2. A cet effet, aucune limitation en nombre n'est imposée, ledit nombre dépendant principalement du temps total de fonctionnement souhaité du dispositif 200 dans ledit environnement hostile 500. Par ailleurs, rien n'exclut non plus que les commutateurs réseau soient adaptés à l'acheminement de signaux selon tout autre protocole de communication filaire connu de l'homme de l'art, et que des moyens de connexion autres que les connecteurs en Y soient mis en oeuvre afin de relier les commutateurs aux bornes de connexion respectives du module de communication 210 et du module de contrôle 220.

Le dispositif 200 comporte également des moyens de commutation électrique adaptés à mettre le deuxième appareil de communication 214 en fonctionnement et d'arrêter le fonctionnement du premier appareil de communication 211 si la valeur calculée est supérieure à la valeur seuil prédéterminée.

Lesdits moyens de commutation permettent donc avantageusement d'exclure toute configuration électronique au cours de laquelle au moins deux appareils de communication fonctionnent de manière simultanée, cela afin de préserver les durées de vie respectives desdits appareils de communication ainsi que d'éviter une potentielle défaillance fonctionnelle liée au fonctionnement simultané desdits appareils électroniques. Il s'agit là d'une des caractéristiques principales du concept de la redondance froide.

Les moyens de commutation électrique sont intégrés au module de contrôle 220 et sont adaptés à activer électriquement lesdits appareils de communication, le microcontrôleur 221 du module de contrôle 220 étant en outre configuré pour qu'un seul appareil de communication fonctionne à la fois en fonction de l'analyse d'intégrité exécutée par ledit microcontrôleur 221. On comprend donc que lesdits moyens de commutation électrique sont pilotés par le microcontrôleur 221 du module de contrôle 220.

Dans un mode particulier de réalisation, lorsque le module de communication 210 comportent lesdits commutateurs réseau, lesdits moyens de commutation électrique du module de contrôle 220 sont aussi adaptés à activer électriquement lesdits commutateurs réseau, le module de contrôle 220 étant en outre configuré pour qu'un seul commutateur réseau fonctionne à la fois en fonction de l'analyse d'intégrité exécutée par ledit module de contrôle 220.

Dans un mode préféré de réalisation, et tel qu'illustré par la figure 1 à titre nullement limitatif, lesdits moyens de commutation électrique comportent des relais électromécaniques bistables 230 respectivement reliés soit à un appareil électronique, soit à un commutateur réseau, du module de communication. Chaque relais électromécanique bistable est de conception connue en soi. Chacun desdits relais est adapté à commuter entre une position autorisant le passage d'un courant électrique et une position empêchant le passage d'un courant électrique, et présente l'avantage de maintenir la position dans laquelle il est configuré lors d'une défaillance du microcontrôleur 221 de sorte à permettre le contrôle de l'alimentation de l'appareil de communication ou du commutateur réseau auquel il est associé. Il peut s'agir par exemple d'une défaillance d'une tension électrique fournie en sortie du microcontrôleur 221 et destinée à alimenter un appareil de communication ou un commutateur réseau. Il convient de noter qu'avant une première mise en marche du dispositif, lesdits relais électromécaniques bistables 230 sont configurés de sorte que seuls les relais associés respectivement au premier appareil de communication 211 et au premier commutateur réseau 217 sont en position de laisser passer un courant électrique, les autres relais étant dès lors en position d'empêcher le passage d'un courant électrique.

Le dispositif 200 comporte également un module d'alimentation 240 destiné à être connecté à une source d'énergie et adapté à fournir l'énergie nécessaire au fonctionnement des modules respectivement de communication 210 et de contrôle 220.

Dans un mode particulier de réalisation, ledit module d'alimentation 240 comporte des régulateurs de tension adaptés à fournir des tensions électriques d'alimentation régulées respectivement au module de contrôle 220 et au module de communication 210. Par exemple, et à titre nullement limitatif, le module d'alimentation 240 fourni des tensions électriques continues de 12 volts et/ou 5 volts et/ou 3,3 volts. En outre, ledit module d'alimentation 240 est aussi adapté à fournir un courant électrique d'intensité prédéterminée. Dans l'exemple illustré par la figure 1 à titre nullement limitatif, le dispositif 200 est dimensionné de sorte à consommer un courant total sensiblement égal à 500 mA (milliampères), la consommation dudit courant total étant répartie entre les consommations respectives des appareils de communication (sensiblement égal à 200 mA), des commutateurs réseau (sensiblement égal à 100 mA), du microcontrôleur (sensiblement égal à 150 mA), des moyens de mesure (sensiblement égal à 15 mA). Rien n'exclut cependant, suivant d'autres exemples non détaillés ici, que le module d'alimentation 240 fournisse d'autres valeurs de tension électriques régulées, et que le dispositif 200 soit dimensionné de sorte à consommer un courant total inférieur ou supérieur à 500 mA.

Dans un mode particulier de réalisation, la source d'énergie du module d'alimentation 240 est externe audit dispositif, et délivre une tension électrique alternative ou bien une tension électrique continue. Par exemple, et à titre nullement limitatif, lesdites tensions électriques alternative et continue sont respectivement de 230 volts et 12 volts. Dans un mode alternatif de réalisation, et tel que représenté dans la figure 1, la source d'énergie du module d'alimentation 240 comprend une batterie électrique 241 intégrée audit dispositif 200 et délivrant une tension électrique continue, par exemple une tension électrique continue de 12 volts. Rien n'exclut cependant, suivant d'autres exemples non détaillés ici, d'avoir une source d'alimentation externe ou interne au dispositif 200 délivrant d'autres valeurs de tensions électriques.

Par ailleurs, le dispositif 200 comporte une carte de support 250 adaptée à acheminer les signaux échangés sur les réseaux de communication respectivement filaire et électrique, ainsi que l'énergie fournie par ledit module d'alimentation 240. Typiquement, et selon le présent mode de réalisation, ladite carte de support 250 est un « fond de panier » (encore appelé « backplane » dans la littérature anglosaxonne) sur lequel sont connectés les modules respectivement de communication 210, de contrôle 220 et d'alimentation 240, et comprenant un bus d'alimentation et de communication adapté audit acheminement de signaux. Ledit fond de panier 250 est de plus intégré à un châssis supportant la structure générale du dispositif 200.

Lesdits moyens de mesure du dispositif 200 comportent au moins une carte électronique de mesure 260 adaptée à fournir et émettre ledit au moins un paramètre sur un réseau de communication électrique, typiquement un réseau de fils électriques de type connu en soi et/ou de pistes conductrices. Ladite au moins une carte de mesure 260 est connectée au microcontrôleur 221 par le réseau de communication électrique.

L'association de la ladite au moins une carte de mesure 260 avec le microcontrôleur 221 forme dès lors un ensemble adapté à détecter toute défaillance du dispositif 200, une défaillance ayant pour origine une différence entre la valeur dudit au moins un paramètre mesuré par ladite au moins une carte de mesure 260 et la valeur seuil prédéterminée obtenue lors de l'étape préalable de caractérisation. Si une telle différence apparaît et est jugée comme critique par le microcontrôleur 221, ce dernier est apte à arrêter l'appareil de communication (ou le commutateur réseau) en fonctionnement, et à en activer un autre, selon le principe même de la redondance froide. Ainsi, l'ensemble formé par ladite au moins une carte de mesure 260 et le microcontrôleur 221 permet de maîtriser et d'anticiper le comportement ainsi que la durée de vie du dispositif 200.

Dans un mode particulier de réalisation, le dispositif 200 comporte une carte de mesure 260 intégrée au module de communication. Ladite carte de mesure 260 comporte une pluralité de composants électroniques reliés entre eux par des pistes conductrices de sorte à former au moins un circuit imprimé, et adaptés à effectuer l'acquisition dudit au moins un paramètre qui est ensuite transmis au module de contrôle 220 dans l'optique d'une analyse d'intégrité.

Dans un autre mode particulier de réalisation, le dispositif comporte une carte de mesure 260 intégrée au module de communication 210 ainsi qu'une carte de mesure 260 intégrée à au moins un autre module du dispositif. Une telle configuration permet avantageusement de faire l'acquisition d'une pluralité de paramètres de fonctionnement respectivement du module de communication 210 et dudit au moins un autre module. Ainsi, lorsqu'un premier paramètre mesuré par le module de communication 210 et un deuxième paramètre mesuré par ledit au moins un autre module sont associés tous deux à une même grandeur physique représentative d'une contrainte subie par le dispositif 200 dans sa globalité, le microcontrôleur 221 est adapté à vérifier la cohérence de mesure entre lesdits premier et deuxième paramètres de sorte à détecter et prévenir toute défaillance dans les moyens de mesure dudit dispositif 200. Lesdits premier et deuxième paramètres sont par exemple associés à une grandeur physique représentative d'une température, d'un débit de dose instantané ou cumulé, etc., et sont représentatifs d'une contrainte altérant la durée de vie du dispositif 200 tout entier. Par dispositif « tout entier » ou « dans sa globalité », on fait référence ici à tous les composants électroniques dudit dispositif 200, indistinctement de la partie du dispositif 200 à laquelle ils appartiennent respectivement.

Dans un mode préféré de réalisation, et tel qu'illustré par la figure 1, les modules respectivement de communication 210, de contrôle 220 et d'alimentation 240 comportent chacun une carte de mesure 260. De telles dispositions permettent avantageusement d'améliorer la robustesse de mesure de paramètres représentatifs d'une contrainte subie par le dispositif 200 dans sa globalité. En outre, de telles dispositions permettent de contrôler les bons fonctionnements respectifs des modules de communication 210, de contrôle 220 et de d'alimentation 240, la carte de mesure d'un module étant dès lors adaptée à acquérir des paramètres représentatifs du bon fonctionnement de ce module. De cette manière, le microcontrôleur 221 du module de contrôle 220 est adapté à analyser les intégrités respectives des modules, pour en évaluer les durées de vie restantes respectives. Cela signifie aussi que chaque module est associé à au moins une valeur seuil prédéterminée qui est comparée avec les paramètres fournis par la carte de mesure associée audit module.

Dans un mode particulier de réalisation, dit mode « V », ledit au moins un paramètre fourni par une carte de mesure 260 d'un module est représentatif d'un signal de tension électrique en sortie du microcontrôleur 221, ladite tension électrique étant destinée à alimenter ledit module, et ladite au moins une valeur seuil prédéterminée comprenant une valeur de tension électrique associée audit module. Il importe de noter que la carte de mesure 260 d'un module est en mesure d'effectuer l'acquisition des tensions électriques de chacun des composants électroniques dudit module, de sorte à pouvoir détecter toute défaillance éventuelle desdits composants électroniques. Lesdites tensions sont classiquement mesurées au moyen de ponts diviseurs de tension branchés respectivement sur des entrées analogiques du microcontrôleur 221. Rien n'exclut cependant d'avoir d'autres moyens de mesure desdites tensions.

Dans un mode particulier de réalisation, dit mode « I », ledit au moins un paramètre fourni par une carte de mesure 260 d'un module est représentatif d'un signal de courant électrique consommé par ledit module, ladite au moins une valeur seuil prédéterminée comprenant une valeur de courant électrique associée audit module. Il importe de noter que la carte de mesure 260 d'un module est en mesure d'effectuer l'acquisition des courants consommés respectivement par chacun des composants électroniques dudit module, de sorte à pouvoir détecter toute défaillance éventuelle desdits composants électroniques.

Dans un mode particulier de réalisation, dit mode « T », ledit au moins un paramètre fourni par une carte de mesure 260 d'un module est représentatif d'un signal de température dudit module, ladite au moins une valeur seuil prédéterminée comprenant une valeur de température associée audit module. Il importe de noter que la carte de mesure 260 d'un module est en mesure d'effectuer l'acquisition des températures subies respectivement par chacun des composants électroniques dudit module, de sorte à pouvoir détecter toute défaillance éventuelle desdits composants électroniques. Les températures respectives des composants électroniques sont mesurées au moyen de capteurs de température, tels que par exemple des sondes PT1000. Rien n'exclut cependant, suivant d'autres exemples non détaillés ici, d'avoir d'autres moyens pour relever lesdites températures.

Dans un mode particulier de réalisation, dit mode « R », ledit au moins un paramètre fourni par une carte de mesure 260 d'un module est représentatif d'un signal de dose instantanée de rayonnements ionisants subie par ledit module et/ou un signal de dose cumulée de rayonnements ionisants subie par ledit module, ladite au moins une valeur seuil prédéterminée comprenant une valeur de dose instantanée et/ou une valeur de dose cumulée respectivement associées audit module. Il importe de noter que la carte de mesure 260 d'un module est en mesure d'effectuer l'acquisition des doses instantanées et/ou doses cumulées subies respectivement par chacun des composants électroniques dudit module, de sorte à pouvoir détecter toute défaillance éventuelle desdits composants électroniques. Les doses instantanées et/ou cumulées sont mesurées au moyen de capteurs de radiation, tels que par exemple des capteurs comportant, comme connu de l'homme de l'art, des transistors MOSFET ainsi que des sondes de température. Rien n'exclut cependant, suivant d'autres exemples non détaillés ici, d'avoir d'autres moyens de mesure desdites doses instantanées et/ou cumulées.

On note que rien n'exclut d'avoir des cartes de mesure 260 fournissant d'autres paramètres que ceux de tension, de courant, de température, de doses instantanées/cumulées, comme par exemple des paramètres relatifs à des contraintes mécaniques (pression, torsion, cisaillement, etc.).

Dans un mode particulier de réalisation, une carte de mesure 260 combine au moins deux desdits modes V, I, T et R. Préférentiellement, chaque carte de mesure 260 combine lesdits quatre modes V, I, T et R, ce qui permet avantageusement une surveillance accrue du bon fonctionnement du dispositif 200 ainsi que de la durée de vie restante des composants électroniques dudit dispositif 200, notamment les appareils de communication et les commutateurs réseau.

Par ailleurs, les moyens de mesure sont configurés de sorte à effectuer la mesure dudit au moins un paramètre de fonctionnement du dispositif 200 de manière itérative. On comprend donc que lesdits moyens de mesure fournissent des valeurs échantillonnées dans le temps du signal associé audit au moins un paramètre mesuré.

Aussi, dans un mode particulier de réalisation, ledit au moins un paramètre (ou de manière équivalente ledit au moins un signal) fourni par une carte de mesure 260 d'un module est mesuré périodiquement suivant une période prédéterminée. De cette manière, ledit au moins paramètre est acheminé sur une base régulière vers le module de contrôle 220 de sorte que le microcontrôleur 221 exécute l'analyse d'intégrité du module associé audit au moins un paramètre selon cette même base. De préférence la période de mesure dudit au moins un paramètre est sensiblement égale à 1 seconde, ce qui permet avantageusement d'avoir un contrôle globalement en temps réel de l'intégrité du dispositif 200. Rien n'exclut cependant que ledit au moins un paramètre soit mesuré périodiquement suivant une période inférieure à 1 seconde, comme par exemple 100 microsecondes, ou supérieure à 1 seconde, ou bien encore non périodiquement.

Le module de contrôle 220 est en outre adapté à détecter une coupure d'alimentation dudit dispositif 200.

A cet effet, dans un mode particulier de réalisation, ledit module de contrôle 220 comporte des moyens de mémorisation adaptés à sauvegarder la configuration électronique dudit dispositif 200 lors de l'activation d'un desdits appareils électroniques de communication du module de communication 210 et/ou lors d'une coupure d'alimentation dudit dispositif 200. Par «configuration électronique », on fait référence ici en particulier, mais non exclusivement, à l'état activé/désactivé de chaque appareil de communication et de chaque commutateur réseau, ainsi qu'aussi à leurs intégrités respectives (niveau de dose cumulée, durée de vie restante, etc.).

Par exemple, et tel qu'illustré par la figure 1 à titre nullement limitatif, lesdits moyens de mémorisation comporte une puce électronique 270 de type EEPROM (acronyme de l'expression anglaise « Electrically-Erasable Programmable Read-Only Memory »), adaptée à enregistrer ladite configuration électronique du dispositif 200 lors d'une coupure d'alimentation. Par la suite, lorsque le dispositif 200 est à nouveau mis en marche, les informations relatives à la configuration électronique précédemment enregistrée sont lues sur la puce 270. Avantageusement, l'enregistrement des informations sur la puce 270 est tripliqué de sorte à limiter le risque d'erreur de lecture sur la puce 270 lors de l'allumage du dispositif 200. Rien n'exclut cependant, suivant d'autres exemples non détaillés ici, d'avoir d'autres moyens de mémorisation, notamment d'autres puces de mémorisation.

Dans un mode particulier de réalisation, le dispositif 200 comporte des diodes électroluminescentes, dites LED (acronyme de l'expression anglaise « Light-Emitting Diode »), adaptées à fournir, par exemple à un utilisateur dudit dispositif, une information visuelle approximative de la durée de vie restante dudit dispositif 200. Par exemple, le dispositif 200 comporte six LED agencées sur un des modules, de sorte à être visibles depuis l'extérieur dudit dispositif 200, à savoir trois LED vertes, 2 LED orange et une LED rouge. Ainsi, lorsque le dispositif 200 est mis en marche pour la première fois dans l'environnement radiatif 500, il dispose d'une durée de vie nominale préalablement déterminée. Les trois diodes vertes sont allumées simultanément et s'éteignent ensuite individuellement au fur et à mesure que la durée de vie du dispositif 200 diminue. Lorsque la moitié de la durée de vie nominale du dispositif 200 est atteinte, les trois LED vertes sont éteintes et la LED orange s'allume. Finalement, La LED orange et la LED rouge respectivement s'éteint et s'allume lorsque le quart de la durée de vie nominale du dispositif 200 est atteinte afin de signifier à un utilisateur extérieur qu'il devient urgent d'envisager un remplacement du dispositif 200. Il est clair que rien n'exclut d'avoir un nombre de LED différent de six ainsi des LED s'allumant/s'éteignant suivant des ratios différents de diminution de la durée de vie du dispositif 200.

La présente invention concerne également un système 300 destiné à fonctionner dans un environnement hostile 500 comportant :
- un premier dispositif 301 tel qu'illustré par la figure 1, destiné à être connecté au moyen de la borne de connexion de son module de communication à un appareil mobile 519 équipé dudit premier dispositif 301,
- un second dispositif 302 tel qu'illustré par la figure 1, destiné à être connecté au moyen de la borne de connexion de son module de communication à un terminal distant 700 installé en dehors de l'environnement hostile 500,
- un ensemble de moyens configurés de façon logicielle pour configurer et commander de manière forcée les fonctionnements respectifs desdits premier 301 et deuxième 302 dispositifs, ainsi que pour contrôler de manière itérative l'intégrité desdits premier 301 et deuxième 302 dispositifs, et destinés en outre à commander de manière forcée les déplacements dudit appareil mobile 519.

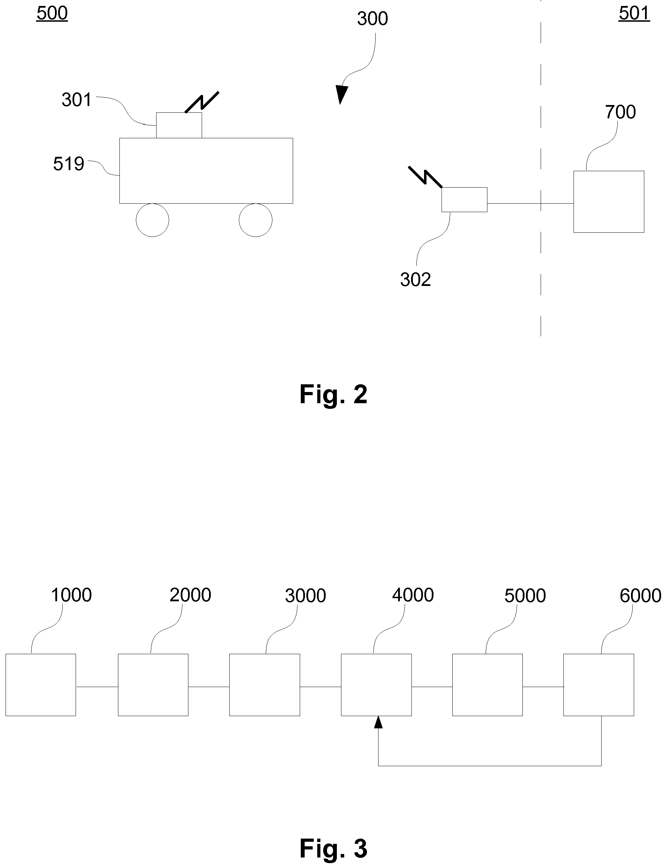

La figure 2 représente schématiquement un mode préféré de réalisation d'un système 300 destiné à fonctionner dans un environnement radiatif 500. Dans le cas présent, ledit appareil mobile 519 est un robot de démantèlement nucléaire destiné à fonctionner dans un environnement radiatif 500 auquel aucune personne (public, travailleur) ne peut avoir accès en raison des rayonnements ionisants émis dans ledit environnement 500 et de la règlementation afférente. En outre, ledit ensemble de moyens configurés de façon logicielle est un produit programme d'ordinateur comportant un ensemble d'instructions de code de programme destinées à être exécutées par un terminal distant 700 qui s'apparente à un ordinateur PC fixe comportant au moins un processeur. Ledit PC 700 est positionné en zone protégée 501, c'est-à-dire qu'il n'est soumis à aucun rayonnement ionisant, et le second dispositif est, quant à lui, positionné dans ledit environnement radiatif 500. Le PC 700 et le second dispositif 302 communiquent entre eux au moyen du réseau de communication filaire, ici de type Ethernet.

On comprend donc que le second dispositif 302 est destiné à conserver une position fixe, contrairement au premier dispositif 301 qui équipe ledit robot 519, et joue avantageusement le rôle de point d'accès Wifi pour ledit PC 700. Dès lors, un utilisateur dudit PC 700 peut communiquer avec les modules du premier dispositif 301 en lui transmettant des signaux suivant un protocole consistant à acheminer ces signaux dans un premier temps par le réseau de communication filaire vers le second dispositif 302, puis par le réseau de communication sans fil vers le premier dispositif 301 dans un deuxième temps. Ledit protocole est utilisé de manière identique pour transmettre des commandes de déplacements au robot 519, les signaux reçus par le premier dispositif 301 étant alors transmis audit robot 519 au moyen du réseau de communication filaire, ledit robot 519 comportant une borne de connexion audit réseau de communication filaire.

De plus, et selon un mode préféré de réalisation, le produit programme d'ordinateur exécuté par le PC 700 fournit une interface homme-machine, dite IHM, ledit PC 700 comportant des moyens d'affichage de ladite IHM comme par exemple un écran, permettant de :
- contrôler l'état de la liaison Wifi (en particulier le niveau et la qualité des signaux Wifi échangés) du premier 301 (respectivement second 302) dispositif, au moyen du protocole de tests également mis en oeuvre par le module de communication de chacun desdits dispositifs. Cela permet notamment d'identifier en temps réel les situations dans lesquelles le robot mobile 519 ne peut plus recevoir de signaux du fait d'un éloignement trop important par rapport au second dispositif 302,
- contrôler le niveau de dose du premier 301 (respectivement second 302) dispositif, et donc déterminer la durée de vie restante du premier 301 (respectivement second 302) dispositif,
- contrôler la configuration électronique du premier 301 (respectivement second 302) dispositif,
- empêcher l'arrêt de fonctionnement d'un appareil de communication appartenant au premier 301 (respectivement second 302) dispositif, dans le cas où par exemple le module de contrôle dudit premier 301 (respectivement second 302) dispositif planifie de le faire suite à une analyse d'intégrité,
- afficher une durée d'indisponibilité de la liaison Wifi du premier 301 (respectivement second 302) dispositif, lorsque par exemple le module de contrôle dudit premier 301 (respectivement second 302) dispositif procède à l'arrêt d'un appareil de communication afin de mettre en fonctionnement un autre appareil de communication,
- transmettre des ordres de type marche/arrêt provisoire/arrêt d'urgence à destination du robot mobile 519 ainsi que des ordres d'exécution de mouvements spécifiques audit robot 519.

Rien n'exclut cependant d'avoir un système 300 comportant un nombre de dispositifs supérieur à deux. Par exemple, et à titre nullement limitatif, le système 300 peut comprendre trois dispositifs, à savoir un premier dispositif équipant le robot mobile 519, un deuxième dispositif relié au terminal distant 700 ainsi qu'un troisième dispositif positionné dans l'environnement radiatif 500 sans être relié physiquement (par exemple au moyen de fils) au terminal distant 700 et au robot 519. Dès lors, ledit troisième dispositif est configuré de sorte à relayer les communications acheminées entre le terminal distant 700 (et donc le deuxième dispositif) et le robot 519 sur le réseau de communication sans fil. Autrement dit, ledit troisième dispositif se comporte comme un relais Wifi entre le terminal distant 700 et le robot 519, ce qui permet avantageusement d'étendre la couverture Wifi entre le terminal 700 et le robot 519 comparativement à une configuration d'un système 300 comportant moins de trois dispositifs. De telles dispositions se généralisent de manière évidente à un nombre quelconque de dispositifs afin d'étendre encore davantage ladite couverture Wifi.

La présente invention concerne également un procédé de prolongation de la durée de vie d'une fonction d'un dispositif 200 tel qu'illustré par la figure 1. La figure 3 représente un organigramme d'un exemple de mise en oeuvre d'un tel procédé.

Ledit procédé comporte une étape préalable 1000 de caractérisation de l'intégrité dudit dispositif 200 de sorte à obtenir ladite au moins une valeur seuil, ledit dispositif 200 étant désactivé à l'issue de ladite étape préalable 1000.

Ladite étape préalable 1000 consiste dès lors en une étape d'évaluation en radiation des composants électroniques des différents modules du dispositif 200, en particulier des appareils de communication du module de communication 210. L'objectif de cette étape est d'identifier des signes de défaillance précurseurs d'une dégradation en cours ou d'une dégradation proche de la fonction de communication du dispositif 200. Ces signes de défaillance sont associés à au moins une valeur seuil de tension, ou de courant, ou de température, ou de dose radiative.

Dans un mode particulier de mise en oeuvre, l'évaluation en radiation des appareils de communication est effectuée en se munissant d'appareils de communication disponibles dans le commerce, ces derniers étant dès lors soumis à des séries de tests, selon des protocoles de tests connus de l'homme de l'art, permettant d'obtenir ladite au moins une valeur seuil. Dans un exemple plus particulier de mise en oeuvre, des tests d'évaluation en radiation sont effectués d'une part sur des composants polarisés et d'autre part sur des composants non polarisés afin de déterminer la meilleure configuration électronique possible lorsque ledit dispositif 200 est introduit au sein de l'environnement radiatif 500. A cet effet, les inventeurs ont constaté que, d'une manière générale, les composants électroniques non polarisés présentaient une meilleure tenue en radiation. Aussi, à l'issue de ladite étape préalable 1000, le dispositif 200 est mis à l'arrêt de sorte qu'aucun de ses composants n'est polarisé avant son introduction au sein de l'environnement radiatif 500.

Le procédé comporte ensuite une étape 2000 d'initialisation du dispositif 200 dans laquelle est défini le routage des appareils de communication dudit dispositif 200.

L'étape 2000 consiste donc à configurer les chemins réseaux par lesquels vont être acheminés les signaux destinés à être échangés entre les différents appareils de communication du dispositif 200 et un terminal distant 700 tel que celui illustré par la figure 2. Cette étape est mise en oeuvre avant introduction du dispositif 200 au sein de l'environnement radiatif 500.

Dans un mode particulier de mise en oeuvre, les tables de routage et de filtrage des signaux échangés sur le réseau de communication sans fil Wifi sont configurées, de manière connue en soi par l'homme de l'art, en fonction des adresses MAC respectives des appareils de communication et dudit terminal distant 700, par exemple au moyen de l'IHM décrite ci-avant.

Lesdits signaux échangés prennent avantageusement la forme de signaux d'information quant à l'intégrité du dispositif 200, ces signaux étant initialement émis par le module de contrôle 220, par exemple au moyen du protocole UDP. A titre d'exemple nullement limitatif de mise en oeuvre, lesdits signaux comportent des trames de quatre types différents :
- trame de type information : il s'agit d'une trame fournissant des informations sur l'état du dispositif 200 (numéro de l'appareil de communication alimenté en énergie, dose instantanée et/ou dose cumulée, etc), et émise par exemple toutes les 10 secondes.
- trame de type maintenance : il s'agit d'une trame émise afin de prévenir de la nécessité d'effectuer une maintenance du dispositif 200, c'est-à-dire une commutation entre deux appareils de communication différents, ou bien encore entre deux commutateurs réseau différents.
- trame de type alerte : il s'agit d'une trame émise afin de prévenir une situation potentiellement critique dans un temps court à l'égard de l'intégrité du dispositif 200. Cette trame identifie notamment le dernier appareil de communication et le dernier commutateur réseau en fonctionnement, ainsi qu'éventuellement le niveau de dose cumulée atteint.
- trame de type défaut : il s'agit d'une trame émise afin de signifier qu'une défaillance critique d'un appareil de communication et/ou d'un commutateur réseau et/ou du module de contrôle et/ou du module d'alimentation est survenue, ladite défaillance compromettant tout ou partie de la mise en oeuvre du dispositif 200.

A l'issue de l'étape 2000, le procédé comporte éventuellement une étape 2500 de mesure de dose afin de mettre à jour la dose cumulée reçue par le dispositif 200. En effet, dans le cas où le dispositif 200 a préalablement été utilisé et que la fonction de communication a été coupée afin que le module de contrôle 220 procède à une maintenance, par exemple en coupant l'alimentation du premier appareil de communication 211 et en activant l'alimentation du deuxième appareil de communication 214, il importe de connaître la dose reçue par le dispositif 200 lors de ladite maintenance si effectivement le dispositif 200 se trouvait dans l'environnement hostile 500.

Le procédé comporte ensuite une étape 3000 de démarrage du dispositif 200 dans laquelle un seul appareil de communication est activé, les autres appareils électroniques restant désactivés.

Dans un mode particulier de mise en oeuvre, dans lequel le dispositif 200 comporte des commutateurs réseau, un seul desdits commutateurs réseau du module de communication est également activé. Ainsi, lorsque le dispositif est mis en marche pour la toute première fois, seuls le premier appareil de communication 211 et le premier commutateur réseau 217 sont activés.

Le procédé comporte ensuite une étape 4000 de mesure d'au moins un paramètre de fonctionnement de l'appareil de communication activé.

Dans un mode particulier de mise en oeuvre, dans lequel le dispositif 200 comporte des commutateurs réseau, on mesure aussi au cours de l'étape 4000 au moins un paramètre de fonctionnement du commutateur réseau activé. Cette étape consiste donc à mesurer des paramètres nécessaires à une analyse d'intégrité du module de communication 210, et plus généralement du dispositif 200.

Pour ce faire, chaque carte de mesure 260 du dispositif 200 mesure des paramètres de tension et/ou de courant et/ou de température et/ou de dose instantanée et/ou de dose cumulée en fonction du mode V et/ou I et/ou T et/ou R dans lequel elle est configurée.

Le procédé comporte ensuite une étape 5000 d'analyse d'intégrité du dispositif 200, dans laquelle, lorsque l'intégrité du module de communication 210 dudit dispositif 200 est altérée, l'appareil électronique activé est désactivé définitivement, et un seul desdits autres appareils électroniques désactivés est alors activé.

L'analyse d'intégrité du dispositif 200 est exécutée par le module de contrôle 220 au moyen dudit au moins un paramètre mesuré lors de l'étape 4000 ainsi qu'au moyen de tests d'échanges de signaux sur le réseau de communication sans fil entre l'appareil de communication en cours de fonctionnement et un terminal distant 700 tel qu'illustré dans la figure 2.

Dans un mode particulier de mise en oeuvre, dans lequel le dispositif 200 comporte des commutateurs réseau, le module de contrôle 220 détecte deux types de défaillances pouvant éventuellement être combinées ensemble :
- défaillance de la fonction de communication du dispositif 200 : dans ce cas qui correspond à une perte de communication entre le dispositif 200 et le terminal distant 700, l'appareil de communication en fonctionnement est désactivé et un deuxième appareil de communication est quant à lui activé. Dès lors, si la fonction de communication du dispositif 200 n'est toujours pas rétablie, le commutateur réseau en fonctionnement est à son tour désactivé et un autre commutateur réseau jusqu'alors désactivé est activé.
- dépassement de la valeur seuil prédéterminée : dans ce cas, le module de contrôle 220 reconfigure le module de communication 210 en désactivant l'appareil de communication et/ou le commutateur en fonctionnement et active un des appareils de communication et/ou un des commutateurs en redondance. Il convient de noter, dans un exemple plus particulier de mise en oeuvre, que lorsque ladite valeur seuil est dépassée, le module de contrôle 220 peut envoyer un message à destination d'un utilisateur du terminal distant 700 afin d'informer ledit utilisateur qu'une reconfiguration du dispositif 200 est nécessaire. Ledit utilisateur peut dès lors renvoyer un message à destination du dispositif 200 afin, soit de confirmer l'exécution de ladite reconfiguration, soit d'inhiber ladite reconfiguration si la fonction de communication doit être maintenue (par exemple dans le cas où le dispositif 200 équipe un appareil mobile 519 exécutant des opérations spécifiques ne pouvant être interrompues).

Lors d'une reconfiguration du dispositif 200, autrement dit lorsque la fonction de communication du dispositif 200 est interrompue le temps d'activer un composant redondant, et lorsque le dispositif 200 équipe un appareil mobile 519, ledit appareil mobile 519 est avantageusement mis dans un état de replis sécuritaire au moyen de l'envoi, depuis le terminal distant 700 et à destination du module de contrôle 220 du dispositif 200, d'une commande d'arrêt d'urgence.

Dans un mode alternatif de mise en oeuvre de l'étape d'analyse d'intégrité du procédé, lorsque l'intégrité du module de communication 210 du dispositif 200 est altérée, l'appareil de communication activé reste activé, les autres appareils électroniques jusqu'alors désactivés restant désactivés, de sorte à maintenir de manière forcée la fonction de communication du module de communication 210. Pour ce faire, un utilisateur du terminal distant 700 émet une commande à cet effet. Une telle manière de procéder permet avantageusement de ne pas couper la communication entre le terminal distant 700 et le dispositif 200. Ainsi, lorsque ledit dispositif 200 doit effectuer une mission prédéterminée, des informations relatives à l'intégrité dudit dispositif 200 continuent à être émises à destination du terminal distant 700 de sorte à intégrer tout risque de défaillance, et l'utilisateur du terminal distant 700 conserve la possibilité de contrôler/commander ledit dispositif 200.

Le procédé comporte enfin une étape 6000 d'évaluation d'une durée de vie restante du dispositif 200 par le module de contrôle 220 dudit dispositif 200.

Dans le présent mode de mise en oeuvre, ladite durée de vie restante est évaluée par comparaison de la dose radiative cumulée par les composants électroniques du dispositif 200 par rapport à la valeur seuil de dose cumulée déterminée lors de l'étape préalable 1000.

Les étapes 4000 à 6000 sont ensuite exécutées de manière itérative jusqu'à ce que la durée de vie restante du dispositif 200 soit épuisée, c'est-à-dire jusqu'à ce que la fonction de communication du dispositif 200 ne soit plus en état de fonctionner.

Préférentiellement, lorsque la durée de vie nominale du dispositif 200 est presque entièrement consommée, et que le dispositif 200 équipe un appareil mobile 519, l'utilisateur d'un terminal distant 700 émet à destination dudit dispositif 200 une commande de rapatriement dudit appareil mobile 519 dans une zone située en dehors de l'environnement hostile 500 afin de procéder au remplacement d'un ou plusieurs modules du dispositif 200, voire du dispositif en entier. Par exemple, une telle commande de rapatriement peut être émise lorsque la durée de vie restante du dispositif 200 en fonctionnement atteint 10% de la durée de vie nominale dudit dispositif 200. Rien n'exclut cependant que la dite commande de rapatriement soit émise pour un ratio différent de 10%.

On note qu'un avantage majeur de l'invention réside dans le fait qu'un utilisateur du terminal distant 700 puisse émettre des commandes à destination du module de contrôle 220 pour forcer l'arrêt de fonctionnement d'un composant redondant du dispositif 200 et donc aussi forcer l'activation d'un autre composant redondant. Ainsi, dans un mode alternatif de mise en oeuvre du procédé, la désactivation d'un appareil de communication et/ou d'un commutateur réseau est commandée avant que la durée de vie dudit appareil de communication et/ou commutateur réseau soit entièrement consommée. De cette manière, un autre appareil de communication et/ou commutateur réseau redondant est activé, ce qui permet à l'appareil de communication et/ou au commutateur réseau qui vient d'être désactivé de se régénérer dans la mesure où il n'est plus polarisé. Cela permet avantageusement de prolonger la durée de vie du dispositif 200 dans la mesure où l'appareil de communication et/ou le commutateur réseau désactivé pourra à nouveau être activé par la suite.

Il convient de noter que l'invention a été décrite en considérant une fonction de communication d'un dispositif destiné à fonctionner dans un environnement radiatif. Rien n'exclut, suivant d'autres exemples, d'avoir d'autres types de fonction du module de fonction (localisation, détection de collisions, etc.), ainsi que d'autres types d'environnement hostile (espace, températures extrêmes, champ électromagnétique intense, etc.).

De manière plus générale, il est à noter que les modes de réalisation et de mise en oeuvre considérés ci-dessus ont été décrits à titre d'exemples non limitatifs, et que d'autres variantes, modifications et perfectionnements sont par conséquent envisageables, étant entendu que ces différentes variantes, modifications et perfectionnements font partie de la portée de l'invention, telle que définie par les revendications qui suivent.

Ainsi, il apparaîtra de manière évidente à l'homme de l'art que le principe général de l'invention repose sur le diagnostic et/ou le pronostic d'une défaillance d'un appareil électronique 900. Ainsi, le dispositif décrit ci-avant peut aussi prendre la forme d'un dispositif de surveillance et/ou de détection de défaillance 100 permettant de sélectionner un appareil électronique 900 selon des critères relatifs aux fonctions désirées.

L'utilisation d'un appareil électronique 900 standard, c'est-à-dire un appareil électronique 900 qui est destiné à être utilisé dans un environnement domestique et/ou dans un environnement industriel, n'est pas destiné à être utilisé dans un environnement radiatif 500, un environnement dont le rayonnement correspond à un débit de dose plus élevé qu'un débit de dose lié à l'environnement radiatif naturel. Dès lors, après une certaine dose de radiation reçue, l'appareil électronique 900 est sujet à certaines défaillances et celles-ci se manifestent par une ou des variations de courants, tensions et/ou températures.

Ainsi l'invention permet d'utiliser un appareil électronique 900 et de le changer avant qu'il ne devienne défaillant.

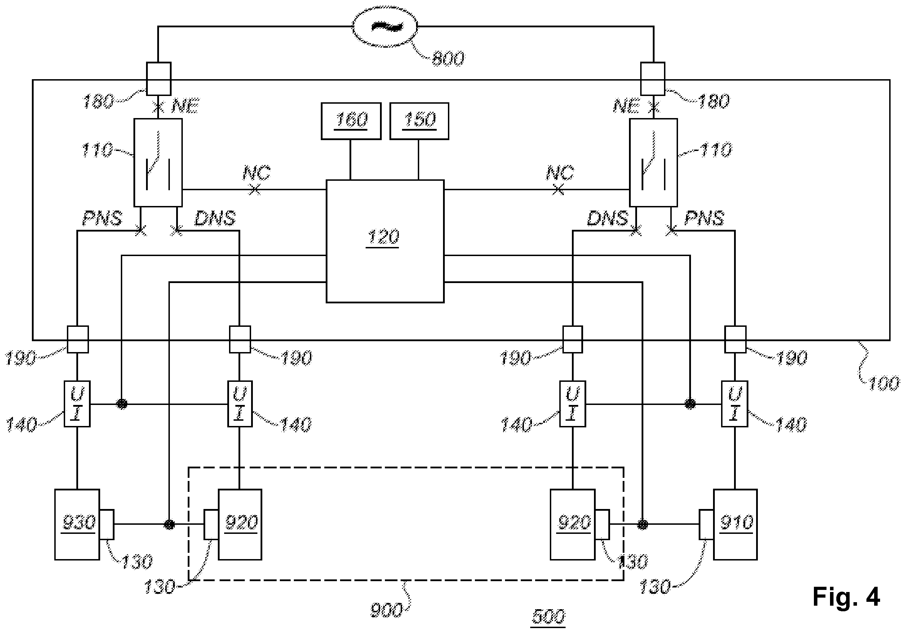

La figure 4 présente un dispositif de surveillance et/ou de détection de défaillance 100 permettant de diagnostiquer et/ou de pronostiquer la défaillance d'un appareil électronique fonctionnant 910 et d'un ensemble d'appareils électroniques exposés 900 comprenant au moins un appareil électronique exposé 920. Dans cet exemple, il sera considéré que l'appareil électronique fonctionnant 910 et l'ensemble d'appareils électroniques exposés 900, un appareil de communication par exemple, et le dispositif de surveillance et/ou de détection de défaillance 100 sont placés dans un environnement radiatif 500.

Comme il peut être observé sur la figure 4, l'appareil électronique fonctionnant 910 ainsi que l'ensemble d'appareils électroniques exposés 900 sont reliés à une source d'énergie 800 par l'intermédiaire du dispositif de surveillance et/ou de détection de défaillance 100, plus précisément, les appareils électroniques 910 et 920 sont connectés à la source d'énergie 800 par l'intermédiaire des dispositifs de connexion d'entrée 180 et aux appareils électroniques 910 et 920 par l'intermédiaire de dispositif de connexion de sortie 190. Dans la suite de l'exemple, il sera considéré que l'ensemble d'appareils électroniques exposés 900 comprend un seul appareil électronique exposé 920.

Les commutateurs 110 comprennent chacun un noeud d'entrée NE et un premier noeud de sortie PNS. Comme il est représenté sur la figure 4, le noeud d'entrée NE est connecté à la source d'énergie 800 par l'intermédiaire du dispositif de connexion d'entrée 180 et le premier noeud de sortie PNS et le deuxième noeud de sortie DNS sont connectés respectivement à l'appareil électronique fonctionnant 910 et à l'appareil électronique exposé 920 par l'intermédiaire du dispositif de connexion de sortie 190.

Les commutateurs 110 comprennent respectivement en outre un noeud de commande NC configuré pour recevoir un signal de commande provenant de l'unité centrale 120. Le signal de commande est adressé individuellement à chaque commutateur, c'est-à-dire qu'un signal de commande est adressé à un commutateur déterminé. Ce signal de commande permet aux commutateurs 111 de fonctionner selon deux modes de fonctionnement : un premier mode de fonctionnement et un deuxième mode de fonctionnement.

Le premier mode de fonctionnement est configuré pour relier électriquement le noeud d'entrée NE du commutateur 110, par exemple, au premier noeud de sortie PNS, ainsi la source d'énergie 800 peut alimenter l'appareil électronique fonctionnant 910.

Dans le cas de l'appareil exposé 920, le commutateur fonctionne selon le deuxième mode de fonctionnement. Ce mode de fonctionnement est configuré pour isoler électriquement le noeud d'entrée NE dudit du premier noeud de sortie PNS. Ainsi, si certaines conditions sont réunies, une unité centrale 120 peut choisir d'interrompre la liaison électrique entre l'appareil électrique fonctionnant 910 et/ou l'appareil exposé 920 et la source d'énergie 800. Afin de prendre une telle décision, l'unité centrale est reliée à un ensemble d'organes de mesure. Cet ensemble peut comprendre un capteur de température 130, de courants et/ou de tensions 140 et/ou un intégrateur 160.

Ces différents capteurs permettent de mesurer le courant, la tension et/ou la température de l'appareil électronique fonctionnant. En effet, lorsque l'appareil électronique fonctionnant 910 est en état de fonctionnement dans le milieu radiatif 500, certains signes de défaillances de l'appareil fonctionnant 910 peuvent être déduits par une variation accrue du courant, de la tension et/ou de la température de fonctionnement révélée par les organes de mesure. En effet, lorsque l'appareil électronique fonctionnant 910 est soumis à une irradiation non susceptible de le détruire, cette irradiation perturbe néanmoins son fonctionnement, autrement dit, ces radiations peuvent modifier le fonctionnement de l'appareil électronique fonctionnant 910 voire le rendre inutilisable. Ce disfonctionnement s'explique en partie par la détérioration des circuits électroniques compris dans l'appareil électronique fonctionnant 910 qui se manifeste soit par une variation de la tension et/ou de la tension soit par une variation de la température de fonctionnement. Cette détérioration survient également dans l'appareil électronique exposé 920 mais dans une moindre mesure. En effet, les appareils électroniques alimentés, associés au dispositif selon l'invention, sont plus sensibles aux conditions extérieures que les appareils électroniques non alimentés.

Dans certains cas, il est fortement préférable de remplacer l'appareil électronique fonctionnant 910 après qu'il ait reçu une dose de radiation supérieure à une valeur limite de dose de radiation. La valeur limite peut être comparée par l'unité centrale avec la valeur de signal de l'intégrateur 160. Ce dernier, c'est-à-dire l'intégrateur 160, intègre de façon continue les doses de radiation qu'il reçoit par unité de temps. Ainsi, il peut s'avérer préférable de changer l'appareil électronique fonctionnant 910 et/ou de commuter sur un appareil électronique exposé 920 de l'ensemble d'appareils électroniques exposés. Lorsque tel est le cas, l'unité centrale 120 peut l'indiquer soit en communiquant par l'appareil de communication vers un poste de contrôle soit par l'intermédiaire d'un indicateur d'état 150. L'indicateur d'état peut comprendre des diodes électroluminescentes de différentes couleurs (DEL) et/ou écran d'affichage de type écran à cristaux liquides (LCD). Par la suite, lors de cette commutation, l'appareil électronique fonctionnant 910 est requalifié par l'unité centrale comme appareil électronique défaillant 930 et l'appareil électronique exposé 920 prélevé de l'ensemble des appareils électroniques exposés est requalifié par l'unité centrale comme appareil électronique fonctionnant.

En effet, le dispositif de surveillance et/ou de détection de défaillance 100 peut permettre de connecter un appareil électronique exposé 920 au deuxième noeud de sortie DNS du commutateur 110 de sorte que lorsque l'unité centrale 120 commande la commutation entre le premier mode de fonctionnement du commutateur 110 et le deuxième mode de fonctionnement, l'unité centrale 120 isole la source d'énergie 800 de l'appareil électronique fonctionnant 910 et relie électriquement l'appareil électronique exposé 920 de sorte à assurer les fonctions de communication dans le cas où l'appareil électronique fonctionnant 910 et exposé 920 sont des appareils de communication. Lors de cette commutation, l'appareil électronique fonctionnant 910 est requalifié par l'unité centrale comme appareil électronique défaillant 930 et l'appareil électronique exposé 920 est requalifié par l'unité centrale comme appareil électronique fonctionnant. Selon un autre mode de réalisation, l'appareil électronique exposé 920 peut être connecté à un commutateur 110 par exemple et plus exactement l'appareil électronique exposé 920 peut être connecté au deuxième noeud de sortie primaire du commutateur 110 comme il peut être observé sur la figure 4.

Le procédé décrit ci-avant peut aussi prendre la forme d'un procédé de surveillance et/ou de détection de défaillance. Un exemple de mise en oeuvre du procédé de surveillance et/ou de détection de défaillance selon l'invention est expliqué ci-après avec l'utilisation d'un appareil électronique fonctionnant 910 tel qu'un appareil de communication par exemple.

Comme il a été expliqué précédemment, afin d'éviter un blindage partiel et/ou total d'un appareil de communication pouvant permettre une atténuation d'une dose de radiation reçue et par la même occasion améliorer la durée de vie de l'appareil de communication dit « blindé », le procédé selon l'invention permet d'utiliser l'appareil de communication sans blindage.

Dans une étape de test préalable, l'appareil électronique 900, dans le cas présent un appareil de communication, est sélectionné selon des critères relatifs à son utilisation. L'appareil électronique fonctionnant 910 et l'ensemble des appareils électroniques exposés est placé dans un milieu dont les contraintes peuvent être thermiques, électromagnétiques et/ou radiatives. Lors de cette étape de test préalable, différentes mesures sont effectuées sur l'appareil électronique fonctionnant 910 et le dispositif de connexion d'entrée 180 est, quant à lui, connecté à une source d'énergie 800 pour pouvoir alimenter l'appareil électronique fonctionnant 910 en énergie électrique par exemple. Les différents organes de mesures sont placés sur l'appareil électronique fonctionnant 910 afin de surveiller la ou les tensions, le ou les courants, la ou les températures des composants et l'intégrateur afin de mesurer la dose reçue par l'appareil électronique fonctionnant 910. Toutes ces mesures sont enregistrées pour pouvoir ensuite déterminer une valeur limite relative à une grandeur caractéristique du milieu hostile, une valeur limite de service de l'appareil électronique fonctionnant 910 et/ou d'une valeur limite d'exposition de l'appareil électronique exposé 320. Ces valeurs permettront par la suite d'établir un critère d'anticipation de défaillance.

Cette étape de test préalable dure tant que l'appareil électronique fonctionnant 910 n'est pas qualifié de défaillant et que l'appareil électronique exposé 920 ne répond plus aux vérifications périodiques de son état de fonctionnement. Lors de ces étapes de vérifications, l'appareil électronique exposé 920 est mise en service pour une durée brève de sorte à vérifier le bon fonctionnement de certaines de ses fonctions.

À la suite de ce séjour, lorsque les appareils électroniques 910 et 920 ne fonctionnent plus, une analyse des valeurs limites est effectuée. En effet, un dysfonctionnement peut se manifester soit par une valeur excessivement élevée par rapport à une référence et/ou par un arrêt inopiné. À des fins de clarté, le terme d'arrêt inopiné signifie, dans ce contexte, que l'arrêt de l'appareil électronique, c'est-à-dire de l'appareil électronique fonctionnant 910 ou, lors des étapes de vérifications périodiques, de l'appareil électronique exposé 920, survient sans suivre un protocole d'arrêt, par exemple. En d'autres termes, la communication émise et/ou reçue par l'appareil électronique fonctionnant 910 et/ou l'appareil électronique exposé 920 s'arrête sans avoir était terminée volontairement.

À l'issu de ces étapes de test préalable, une valeur limite relative à une grandeur caractéristique du milieu hostile, d'une valeur limite de service de l'appareil électronique fonctionnant 910 et/ou d'une valeur limite d'exposition de l'appareil électronique exposé 920 est déterminée de sorte à pouvoir établir un critère d'anticipation de défaillance correspondant à une valeur d'anticipation inférieure à au moins une des valeurs parmi la valeur limite relative à la grandeur caractéristique, valeur limite de service et valeur limite d'exposition.

Lors d'une étape d'utilisation, ce procédé de surveillance et/ou de détection de défaillance permet d'optimiser la durée de vie de l'ensemble dispositif-appareil électronique.

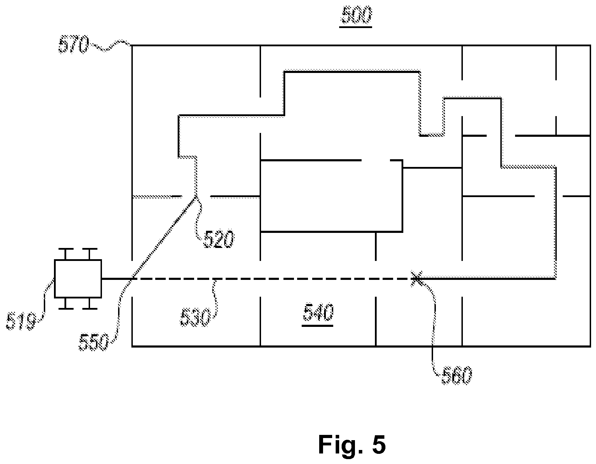

Prenons par exemple le cas décrit de la figure 5, dans lequel un appareil électronique fonctionnant 910 est connecté au dispositif de connexion de sortie 191 et un appareil électronique exposé 920 est connecté au dispositif de connexion de sortie 192. L'appareil électronique fonctionnant 910 est mis sous tension et est surveillé par le dispositif de surveillance et/ou de détection de défaillance 100. Cet ensemble dispositif-appareil électronique peut être placé sur une unité mobile 519 et doit se déplacer au sein d'un milieu hostile.

L'unité mobile 519 doit par exemple se déplacer entre un point de départ 550 et un point d'arrivé 560. Pour ce faire, l'unité mobile 519 peut choisir entre un chemin court 530 et un chemin long 520.

En empruntant le chemin court 530 et en passant par un milieu très contraignant 540, le chemin court 530 pourrait permettre l'apparition de défaillance assez rapidement et donc diminuer la durée de vie de l'ensemble dispositif-appareil électronique et par conséquent immobiliser l'unité mobile 519 sur le chemin court 530.

Selon la deuxième possibilité, c'est-à-dire en empruntant le chemin long 520, l'unité mobile 519 peut se préserver et optimiser ainsi sa durée de vie et faire le chemin inverse.

Dans les deux cas, lorsqu'une valeur de signal émise par l'un des organes de mesures 130, 140 et/ou 160 dépasse une valeur limite, le dispositif de surveillance et/ou de détection de défaillance 100 commande la commutation du commutateur 110 entre le premier mode de fonctionnement et le deuxième mode de fonctionnement. La dose de rayonnement passive reçue par l'appareil électronique exposé 920 durant le temps d'exposition, lorsque celui-ci était hors tension, est convertie en dose de rayonnement active reçue par l'appareil électronique qualifié de fonctionnant durant le temps de fonctionnement, lorsque celui-ci est sous tension. Le dispositif de surveillance et/ou de détection de défaillance 100 intègre la dose de rayonnement active au procédé de surveillance et/ou de détection de défaillance. L'appareil électronique exposé 920 est mis sous tension et est requalifié en appareil électronique fonctionnant 910. Les valeurs de tensions, de courants et/ou de température de l'appareil électronique fonctionnant 920 sont surveillées.

D'un point de vue du dispositif de surveillance et/ou de détection de défaillance, l'unité centrale prélève et connecte à une source d'énergie un appareil électronique exposé de l'ensemble d'appareils électroniques exposés par l'intermédiaire d'un commutateur. L'unité centrale qualifie l'appareil électronique exposé prélevé en appareil électronique fonctionnant puisque il est désormais relié à la source d'énergie de sorte à le mettre en service. Après avoir reçu les signaux de diagnostic d'au moins un organe de mesures, mesurant une grandeur caractéristique du milieu hostile et/ou de l'appareil électronique fonctionnant, l'unité centrale 120 évalue le critère d'anticipation de défaillance sur la base de ces signaux de diagnostic et d'au moins une valeur limite.

Si, lors du déplacement de l'unité mobile l'appareil électronique fonctionnant venait à manifester des signes de défaillances, l'unité centrale le requalifie en appareil électronique défaillant et le classe dans un ensemble d'appareils électroniques défaillants en l'isolant électriquement de la source d'énergie. Un appareil électronique exposé de l'ensemble d'appareils électroniques exposés est prélevé afin d'assurer la continuité de la mission en réitérant les étapes de prélèvement, de connexion, de qualification, de réception, d'évaluation, de désignation et de classement jusqu'à que le nombre d'appareils électroniques exposés soit épuisé.

## Revendications

1. Dispositif (200) destiné à fonctionner dans un environnement hostile (500) affectant son intégrité de fonctionnement, ledit dispositif (200) comportant un premier module électronique (210), dit module de fonction, comprenant au moins un premier appareil électronique (211) adapté à fournir une fonction audit module de fonction (210), ledit module de fonction (210) comporte au moins un deuxième appareil électronique (214) adapté à fournir au dispositif (200) la même fonction que le premier appareil électronique (211), ce deuxième appareil électronique (214) n'étant pas alimenté en énergie tant que le premier appareil électronique (211) est alimenté, et ledit dispositif (200) comporte également :
- des moyens de mesure itérative d'au moins un paramètre de fonctionnement du dispositif (200),
- des moyens de contrôle de l'intégrité du dispositif (200) par comparaison d'une valeur calculée sur la base de ce au moins un paramètre avec au moins une valeur seuil prédéterminée,
- des moyens de commutation électrique adaptés à mettre le deuxième appareil électronique (214) en fonctionnement et d'arrêter le fonctionnement du premier appareil électronique (211) si la valeur calculée est supérieure à la valeur seuil prédéterminée.

2. Dispositif selon la revendication 1, **caractérisé en ce que** les appareils électroniques du module de fonction (210) sont respectivement adaptés à émettre/recevoir des signaux sur un réseau de communication filaire, et **en ce que** :
- lesdits moyens de mesure comportent au moins une carte électronique de mesure (260) adaptée à fournir et émettre ledit au moins un paramètre sur un réseau de communication électrique,
- lesdits moyens de contrôle comportent un module de contrôle (220) comportant un microcontrôleur (221) adapté à analyser l'intégrité du dispositif (200) par comparaison dudit au moins un paramètre fourni par ladite au moins une carte de mesure (260) avec au moins une valeur seuil prédéterminée,
- les moyens de commutation électrique sont intégrés au module de contrôle (220) et sont adaptés à activer électriquement lesdits appareils électroniques, le microcontrôleur (221) étant en outre configuré pour qu'un seul appareil électronique fonctionne à la fois en fonction de l'analyse d'intégrité exécutée par ledit microcontrôleur (221),
- le dispositif comporte un module d'alimentation (240) destiné à être connecté à une source d'énergie et adapté à fournir l'énergie nécessaire au fonctionnement des modules respectivement de fonction (210) et de contrôle (220),
- le dispositif comporte une carte de support (250) adaptée à acheminer les signaux échangés sur les réseaux de communication respectivement filaire et électrique, ainsi que l'énergie fournie par ledit module d'alimentation (240).

3. Dispositif selon la revendication 2, **caractérisé en ce que** les modules de contrôle (220) et de fonction (210) comportent chacun une borne de connexion (216, 226) au réseau de communication filaire, le module de fonction (210) comportant un premier commutateur réseau (217) et au moins un deuxième commutateur réseau (218), chacun desdits commutateurs réseau étant adapté à relier les appareils électroniques du module de fonction (210) auxdites bornes de connexion, et **en ce que** les moyens de commutation électrique du module de contrôle (220) sont en outre adaptés à activer électriquement lesdits commutateurs réseau, le module de contrôle (220) étant en outre configuré pour qu'un seul commutateur réseau fonctionne à la fois en fonction de l'analyse d'intégrité exécutée par ledit module de contrôle (220).

4. Dispositif selon la revendication 3, **caractérisé en ce que** lesdits moyens de commutation électrique comportent des relais électromécaniques bistables (230) respectivement reliés soit à un appareil électronique, soit à un commutateur réseau, du module de fonction (210).

5. Dispositif selon l'une des revendications 2 à 4, **caractérisé en ce qu'**il comporte une carte de mesure (260) intégrée au module de fonction (210).

6. Dispositif selon l'une des revendications 2 à 5, **caractérisé en ce qu'**il comporte une carte de mesure (260) intégrée au module de contrôle (220).

7. Dispositif selon l'une des revendications 2 à 6, **caractérisé en ce qu'**il comporte une carte de mesure (260) intégrée au module d'alimentation (240).

8. Dispositif selon l'une des revendications 5 à 7, **caractérisé en ce que** ledit au moins un paramètre fourni par une carte de mesure (260) d'un module est représentatif d'un signal de tension électrique alimentant ledit module, et **en ce que** ladite au moins une valeur seuil prédéterminée comprend une valeur de tension électrique associée audit module.

9. Dispositif selon l'une des revendications 5 à 8, **caractérisé en ce que** ledit au moins un paramètre fourni par une carte de mesure (260) d'un module est représentatif d'un signal de courant électrique consommé par ledit module, et **en ce que** ladite au moins une valeur seuil prédéterminée comprend une valeur de courant électrique associée audit module.

10. Dispositif selon l'une des revendications 5 à 9, **caractérisé en ce que** ledit au moins un paramètre fourni par une carte de mesure (260) d'un module est représentatif d'un signal de température dudit module, et **en ce que** ladite au moins une valeur seuil prédéterminée comprend une valeur de température associée audit module.

11. Dispositif selon l'une des revendications 5 à 10, **caractérisé en ce que** ledit au moins un paramètre fourni par une carte de mesure (260) d'un module est représentatif d'un signal de dose instantanée de rayonnements ionisants subie par ledit module et/ou un signal de dose cumulée de rayonnements ionisants subie par ledit module, et **en ce que** ladite au moins une valeur seuil prédéterminée comprend une valeur de dose instantanée et/ou une valeur de dose cumulée respectivement associées audit module.

12. Dispositif selon l'une des revendications 5 à 11, **caractérisé en ce que** ledit au moins un signal fourni par une carte de mesure (260) d'un module est mesuré périodiquement suivant une période prédéterminée, de préférence une période sensiblement égale à 1 seconde.

13. Dispositif selon l'une des revendications 2 à 12, **caractérisé en ce que** le module de contrôle (220) est adapté à détecter une coupure d'alimentation dudit dispositif (200), et **en ce qu'**il comporte des moyens de mémorisation adaptés à sauvegarder la configuration électronique dudit dispositif (200) lors de l'activation d'un desdits appareils électroniques du module de fonction (210) et/ou lors d'une coupure d'alimentation dudit dispositif (200).

14. Dispositif selon la revendication 13, **caractérisé en ce que** lesdits moyens de mémorisation comportent une puce électronique (270) de type EEPROM.

15. Dispositif selon l'une des revendications 2 à 14, **caractérisé en ce que** le module d'alimentation (240) comporte des régulateurs de tension adaptés à fournir des tensions électriques d'alimentation régulées respectivement au module de contrôle (220) et au module de fonction (210).

16. Dispositif selon la revendication 2 à15, **caractérisé en ce que** la source d'énergie du module d'alimentation (240) est externe audit dispositif, et délivre une tension électrique alternative ou bien une tension électrique continue.

17. Dispositif selon la revendication 2 à15, **caractérisé en ce que** la source d'énergie du module d'alimentation (240) comprend une batterie électrique (241) intégrée audit dispositif et délivrant une tension électrique continue.

18. Dispositif selon l'une des revendications 2 à 17, **caractérisé en ce que** la fonction fournie par les appareils électroniques du module de fonction (210) est une fonction de communication sur un réseau de communication sans fil selon un protocole prédéterminé, chaque appareil de communication comportant une carte de communication (212) adaptée à acheminer des signaux selon ledit protocole ainsi qu'une antenne (213) omnidirectionnelle ou bien encore directive selon l'utilisation à laquelle est destinée le dispositif (200).

19. Système (300) destiné à fonctionner dans un environnement hostile (500) **caractérisé en ce qu'**il comporte :
- un premier dispositif (301) selon l'une des revendications 2 à 18, destiné à être connecté au moyen de la borne de connexion de son module de fonction (210) à un appareil mobile (519), par exemple un robot de démantèlement nucléaire, équipé dudit premier dispositif (301),
- un second dispositif (302) selon l'une des revendications 2 à 18, destiné à être connecté au moyen de la borne de connexion de son module de fonction (210) à un terminal distant (700) installé en dehors de l'environnement hostile (500),
- un ensemble de moyens configurés de façon logicielle pour configurer et commander de manière forcée les fonctionnements respectifs desdits premier (301) et deuxième (302) dispositifs, ainsi que pour contrôler de manière itérative l'intégrité desdits premier (301) et deuxième (302) dispositifs, et destinés en outre à commander de manière forcée les déplacements dudit appareil mobile (519).

20. Système selon la revendication 19, **caractérisé en ce que** ledit ensemble de moyens configurés de façon logicielle est un produit programme d'ordinateur comportant un ensemble d'instructions de code de programme destinées à être exécutées par ledit terminal distant (700), de préférence un ordinateur PC fixe comportant au moins un processeur.

21. Procédé de prolongation de la durée de vie d'une fonction d'un dispositif (200) selon l'une des revendications 1 à 18, ledit procédé comportant une étape préalable (1000) de caractérisation de l'intégrité dudit dispositif de sorte à obtenir ladite au moins une valeur seuil, ledit dispositif étant désactivé à l'issue de ladite étape préalable (1000), ledit procédé étant en outre **caractérisé en ce qu'**il comporte les étapes successives suivantes :
- une étape (2000) d'initialisation du dispositif dans laquelle est défini le routage des appareils électroniques dudit dispositif,
- une étape (3000) de démarrage du dispositif dans laquelle un seul appareil électronique est activé, les autres appareils électroniques restant désactivés,
- une étape (4000) de mesure d'au moins un paramètre de fonctionnement de l'appareil électronique activé,
- une étape (5000) d'analyse d'intégrité du dispositif, dans laquelle, lorsque l'intégrité du module de fonction dudit dispositif est altérée, l'appareil électronique activé est désactivé définitivement, et un seul desdits autres appareils électroniques désactivés est activé, ou bien l'appareil électronique activé reste activé, et lesdits autres appareils électroniques désactivés restent désactivés,
- une étape (6000) d'évaluation d'une durée de vie restante du dispositif par le module de contrôle dudit dispositif,
les étapes de mesure (4000), d'analyse (5000) et d'évaluation (6000) étant exécutées de manière itérative jusqu'à ce que la durée de vie restante d'un appareil électronique précédemment activé puis désactivé soit restaurée, ou que la durée de vie restante du dispositif (200) soit épuisée.

## Patentansprüche

1. Vorrichtung (200), dazu bestimmt, um in einer rauen Umgebung (500) zu funktionieren, die ihre Funktionsintegrität beeinträchtigt, wobei die Vorrichtung (200) ein erstes elektronisches Modul (210), genannt Funktionsmodul, umfasst, beinhaltend mindestens ein erstes elektronisches Gerät (211), angepasst, um dem Funktionsmodul (210) eine Funktion bereitzustellen, wobei das Funktionsmodul (210) mindestens ein zweites elektronisches Gerät (214) umfasst, angepasst, um der Vorrichtung (200) die gleiche Funktion wie dem ersten elektronischen Gerät (211) bereitzustellen, wobei dieses zweite elektronische Gerät (214) nicht so mit Energie versorgt wird wie das erste elektronische Gerät (211) versorgt wird, und wobei die Vorrichtung (200) ebenfalls umfasst:
- iterative Messmittel mindestens eines Funktionsparameters der Vorrichtung (200),
- Kontrollmittel der Integrität der Vorrichtung (200) durch Vergleich eines auf der Basis dieses mindestens einen Parameters berechneten Werts mit mindestens einem vorher festgelegten Schwellenwert,
- elektrische Umschaltmittel, angepasst, um das zweite elektronische Gerät (214) in Funktion zu setzen und die Funktion des ersten elektronischen Geräts (211) zu stoppen, wenn der berechnete Wert oberhalb des vorher festgelegten Schwellenwerts liegt.

2. Vorrichtung nach Anspruch 1, **dadurch gekennzeichnet, dass** die elektronischen Geräte des Funktionsmoduls (210) jeweils angepasst sind, um in einem drahtgebundenen Kommunikationsnetz Signale zu senden/empfangen, und dadurch, dass:
- die Messmittel mindestens eine elektronische Messkarte (260) umfassen, angepasst, um den mindestens einen Parameter in einem elektrischen Kommunikationsnetz bereitzustellen und zu senden,
- die Kontrollmittel ein Kontrollmodul (220) umfassen, umfassend einen Mikrocontroller (221), angepasst, um die Integrität der Vorrichtung (200) durch Vergleich des mindestens einen durch die mindestens eine Messkarte (260) bereitgestellten Parameters mit mindestens einem vorher festgelegten Schwellenwert zu analysieren,
- die elektrischen Umschaltmittel in dem Kontrollmodul (220) integriert sind und angepasst sind, um die elektronischen Geräte elektrisch zu aktiven, wobei der Mikrocontroller (221) des Weiteren konfiguriert ist, damit ein einzelnes elektronisches Gerät gleichzeitig entsprechend der durch den Mikrocontroller (221) ausgeführten Integritätsanalyse funktioniert,
- die Vorrichtung ein Versorgungsmodul (240) umfasst, dazu bestimmt, um an eine Energiequelle angeschlossen zu werden, und angepasst, um die zum Funktionieren der jeweiligen Funktions- (210) und Kontrollmodule (220) notwendige Energie bereitzustellen,
- die Vorrichtung eine Trägerkarte (250) umfasst, angepasst, um die in dem jeweiligen drahtgebundenen und elektrischen Kommunikationsnetz ausgetauschten Signale, sowie die durch das Versorgungsmodul (240) bereitgestellte Energie, zu leiten.

3. Vorrichtung nach Anspruch 2, **dadurch gekennzeichnet, dass** die Kontroll- (220) und Funktionsmodule (210) jedes eine Klemme (216, 226) zum Anschluss an das drahtgebundene Kommunikationsnetz umfassen, das Funktionsmodul (210) einen ersten Netzschalter (217) und mindestens einen zweiten Netzschalter (218) umfasst, wobei jeder der Netzschalter angepasst ist, um die elektronischen Geräte des Funktionsmoduls (210) mit den Klemmen zum Anschluss zu verbinden, und dadurch, dass die elektrischen Umschaltmittel des Kontrollmoduls (220) des Weiteren angepasst sind, um die Netzschalter elektrisch zu aktivieren, wobei das Kontrollmodul (220) des Weiteren konfiguriert ist, damit ein einzelner Netzschalter gleichzeitig entsprechend der durch das Kontrollmodul (220) ausgeführten Integritätsanalyse funktioniert.

4. Vorrichtung nach Anspruch 3, **dadurch gekennzeichnet, dass** die elektrischen Umschaltmittel bistabile elektromechanische Relais (230) umfassen, jeweils verbunden mit entweder einem elektronischen Gerät oder mit einem Netzschalter des Funktionsmoduls (210).

5. Vorrichtung nach einem der Ansprüche 2 bis 4, **dadurch gekennzeichnet, dass** sie eine in das Funktionsmodul (210) integrierte Messkarte (260) umfasst.

6. Vorrichtung nach einem der Ansprüche 2 bis 5, **dadurch gekennzeichnet, dass** sie eine in das Kontrollmodul (220) integrierte Messkarte (260) umfasst.

7. Vorrichtung nach einem der Ansprüche 2 bis 6, **dadurch gekennzeichnet, dass** sie eine in das Versorgungsmodul (240) integrierte Messkarte (260) umfasst.

8. Vorrichtung nach einem der Ansprüche 5 bis 7, **dadurch gekennzeichnet, dass** der mindestens eine durch die Messkarte (260) bereitgestellte Parameter eines Moduls repräsentativ ist für ein Signal elektrischer Spannung, die das Modul versorgt, und dadurch, dass der mindestens eine vorher festgelegte Schwellenwert einen mit dem Modul assoziierten Wert elektrischer Spannung beinhaltet.

9. Vorrichtung nach einem der Ansprüche 5 bis 8, **dadurch gekennzeichnet, dass** der mindestens eine durch die Messkarte (260) bereitgestellte Parameter eines Moduls repräsentativ ist für ein Signal elektrischer Stroms, der durch das Modul verbraucht wird, und dadurch, dass der mindestens eine vorher festgelegte Schwellenwert einen mit dem Modul assoziierten Wert elektrischen Stroms beinhaltet.

10. Vorrichtung nach einem der Ansprüche 5 bis 9, **dadurch gekennzeichnet, dass** der mindestens eine durch die Messkarte (260) bereitgestellte Parameter eines Moduls repräsentativ ist für ein Temperatursignal des Moduls, und dadurch, dass der mindestens eine vorher festgelegte Schwellenwert einen mit dem Modul assoziierten Temperaturwert beinhaltet.

11. Vorrichtung nach einem der Ansprüche 5 bis 10, **dadurch gekennzeichnet, dass** der mindestens eine durch die Messkarte (260) bereitgestellte Parameter eines Moduls repräsentativ ist für ein Signal momentaner Dosis ionisierender Strahlen, die von dem Modul erlitten wird, und/oder eines Signals kumulierter Dosis ionisierender Strahlen, die von dem Modul erlitten wird, und dadurch, dass der mindestens eine vorher festgelegte Schwellenwert einen jeweils mit dem Modul assoziierten Wert momentaner Dosis und/oder einen Wert kumulierter Dosis beinhaltet.

12. Vorrichtung nach einem der Ansprüche 5 bis 11, **dadurch gekennzeichnet, dass** das mindestens eine von der Messkarte (260) bereitgestellte Signal einem vorher festgelegten Zeitraum folgend regelmäßig gemessen wird, vorzugsweise einem Zeitraum im Wesentlichen gleich 1 Sekunde.

13. Vorrichtung nach einem der Ansprüche 2 bis 12, **dadurch gekennzeichnet, dass** das Kontrollmodul (220) angepasst ist, um eine Unterbrechung der Versorgung der Vorrichtung (200) zu detektieren, und dadurch, dass sie Speichermittel umfasst, angepasst, um die elektronische Konfiguration der Vorrichtung (200) bei der Aktivierung eines der elektronischen Geräte des Funktionsmoduls (210) und/oder bei einer Unterbrechung der Versorgung der Vorrichtung (200) zu sichern.

14. Vorrichtung nach Anspruch 13, **dadurch gekennzeichnet, dass** die Speichermittel einen Elektronikchip (270) des EEPROM-Typs umfassen.

15. Vorrichtung nach einem der Ansprüche 2 bis 14, **dadurch gekennzeichnet, dass** das Versorgungsmodul (240) Spannungsregler umfasst, angepasst, um dem Kontrollmodul (220) und dem Funktionsmodul (210) jeweils geregelte elektrische Versorgungsspannungen bereitzustellen.

16. Vorrichtung nach Anspruch 2 bis 15, **dadurch gekennzeichnet, dass** die Energiequelle des Versorgungsmoduls (240) der Vorrichtung extern vorliegt, und eine elektrische Wechselspannung oder auch eine elektrische Gleichspannung liefert.

17. Vorrichtung nach Anspruch 2 bis 15, **dadurch gekennzeichnet, dass** die Energiequelle des Versorgungsmoduls (240) der Vorrichtung eine elektrische Batterie (241) in der Vorrichtung integriert und eine elektrische Gleichspannung liefernd beinhaltet.

18. Vorrichtung nach einem der Ansprüche 2 bis 17, **dadurch gekennzeichnet, dass** die durch die elektronischen Geräte des Funktionsmoduls (210) bereitgestellte Funktion eine Funktion zur Kommunikation in einem drahtlosen Kommunikationsnetz gemäß einem vorher festgelegten Protokoll ist, wobei jedes Kommunikationsgerät eine Kommunikationskarte (212), angepasst, um Signale gemäß dem Protokoll zu leiten, sowie eine Rundstrahl- oder auch Richtantenne (213) gemäß der Verwendung, zu der die Vorrichtung (200) bestimmt ist, umfasst.

19. System (300), dazu bestimmt, um in einer rauen Umgebung (500) zu funktionieren, **dadurch gekennzeichnet, dass** es umfasst:
- eine erste Vorrichtung (301) nach einem der Ansprüche 2 bis 18, dazu bestimmt, mittels der Klemme zum Anschluss ihres Funktionsmoduls (210) an ein Mobilgerät (519) angeschlossen zu werden, zum Beispiel einen Roboter zum kerntechnischen Rückbau, ausgestattet mit der ersten Vorrichtung (301),
- eine zweite Vorrichtung (301) nach einem der Ansprüche 2 bis 18, dazu bestimmt, mittels der Klemme zum Anschluss ihres Funktionsmoduls (210) an ein entferntes Endgerät (700) angeschlossen zu werden, das außerhalb der rauen Umgebung (500) installiert ist,
- ein Ensemble von mittels Software konfigurierten Mitteln zum Konfigurieren und Befehligen der jeweiligen Funktionen der ersten (301) und zweiten (302) Vorrichtung auf erzwungene Weise, sowie zum Kontrollieren der Integrität der ersten (301) und zweiten (302) Vorrichtung auf iterative Weise, und des Weiteren dazu bestimmt, die Bewegungen des mobilen Geräts (519) auf erzwungene Weise zu befehligen.

20. System nach Anspruch 19, **dadurch gekennzeichnet, dass** das Ensemble von mittels Software konfigurierten Mitteln ein Computerprogrammprodukt ist, umfassend ein Ensemble von Programmcodeanweisungen, dazu bestimmt, durch das entfernte Endgerät (700), vorzugsweise einem ortsfesten PC-Computer, umfassend mindestens einen Prozessor, ausgeführt zu werden.

21. Verfahren zur Verlängerung der Lebensdauer einer Funktion einer Vorrichtung (200) nach einem der Ansprüche 1 bis 18, wobei das Verfahren einen vorhergehenden Schritt (1000) zur Charakterisierung der Integrität der Vorrichtung derart umfasst, um den mindestens einen Schwellenwert zu erhalten, wobei die Vorrichtung am Ende von dem vorhergehenden Schritt (1000) deaktiviert wird, wobei das Verfahren des Weiteren **dadurch gekennzeichnet ist, dass** es die folgenden aufeinanderfolgenden Schritte umfasst:
- einen Schritt (2000) zur Installation der Vorrichtung, wobei das Routing der elektronischen Geräte der Vorrichtung definiert wird,
- einen Schritt (3000) zur Inbetriebnahme der Vorrichtung, wobei ein einzelnes elektronisches Gerät aktiviert wird, die anderen elektronischen Geräte deaktiviert bleiben,
- einen Schritt (4000) zum Messen mindestens eines Funktionsparameters des aktivierten elektronischen Geräts,
- einen Schritt (5000) zur Integritätsanalyse der Vorrichtung, wobei, wenn die Integrität des Funktionsmoduls der Vorrichtung verändert ist, das aktivierte elektronische Gerät dauerhaft deaktiviert wird und ein einzelnes der anderen deaktivierten elektronischen Geräte aktiviert wird, oder auch das aktivierte elektronische Gerät aktiviert bleibt und die anderen deaktivierten elektronischen Geräte deaktiviert bleiben,
- einen Schritt (6000) der Bewertung einer verbleibenden Lebensdauer der Vorrichtung durch das Kontrollmodul der Vorrichtung,
wobei die Schritte zur Messung (4000), zur Analyse (5000) und zur Bewertung (6000) auf iterative Art ausgeführt werden, bis die verbleibende Lebensdauer eines vorher aktivierten, danach deaktivierten elektronischen Geräts wiederhergestellt ist, oder die verbleibende Lebensdauer der Vorrichtung (200) erschöpft ist.

## Claims

1. Device (200) intended to operate in a hostile environment (500) affecting its operating integrity, said device (200) including a first electronic module (210), called function module, comprising at least one first electronic apparatus (211) adapted to provide a function to said function module (210), said function module (210) includes at least one second electronic apparatus (214) adapted to provide the device (200) with the same function as the first electronic apparatus (211), this second electronic apparatus (214) not being supplied with energy until the first electronic apparatus (211) is powered, and said device (200) also includes:
- means for iterative measurement of at least one operating parameter of the device (200),
- means for monitoring the integrity of the device (200) by comparing a value calculated on the basis of this at least one parameter with at least one predetermined threshold value,
- electrical switching means adapted to set the second electronic apparatus (214) in operation and to stop the operation of the first electronic apparatus (211) if the calculated value is greater than the predetermined threshold value.

2. Device according to claim 1, **characterised in that** the electronic apparatuses of the function module (210) are respectively adapted to transmit/receive signals on a wired communication network, and **in that**:
- said measuring means include at least one electronic measuring card (260) adapted to provide and transmit said at least one parameter on an electrical communication network,
- said monitoring means include a monitoring module (220) including a microcontroller (221) adapted to analyse the integrity of the device (200) by comparing said at least one parameter provided by said at least one measuring card (260) with at least one predetermined threshold value,
- the electrical switching means are integrated into the monitoring module (220) and are adapted to electrically activate said electronic apparatuses, the microcontroller (221) being further configured so that only one electronic device operates at a time depending on the integrity analysis executed by said microcontroller (221),
- the device includes a power module (240) intended to be connected to an energy source and adapted to provide the energy necessary for the operation of the modules respectively the function (210) and monitoring (220) modules,
- the device includes a support card (250) adapted for conveying the signals exchanged on the communication networks respectively wired and electrical communication networks, as well as the energy provided by said power module (240).

3. Device according to claim 2, **characterised in that** the monitoring (220) and function (210) modules each include a terminal (216, 226) of connection to the wired communication network, the function module (210) including a first network switch (217) and at least one second network switch (218), each of said network switches being adapted to connect the electronic apparatuses of the function module (210) to said connection terminals, and **in that** the electrical switching means of the monitoring module (220) are further adapted to electrically activate said network switches, the monitoring module (220) being further configured so that only one network switch operate at a time depending on the integrity analysis executed by said monitoring module (220).

4. Device according to claim 3, **characterised in that** said electrical switching means include bistable electromechanical relays (230) respectively connected either to an electronic apparatus, or to a network switch, of the function module (210).

5. Device according to one of claims 2 to 4, **characterised in that** it includes a measuring card (260) integrated into the function module (210).

6. Device according to one of claims 2 to 5, **characterised in that** it includes a measuring card (260) integrated into the monitoring module (220).

7. Device according to one of claims 2 to 6, **characterised in that** it includes a measuring card (260) integrated into the power module (240).

8. Device according to one of claims 5 to 7, **characterised in that** said at least one parameter provided by a measuring card (260) of a module is representative of a voltage signal powering said module, and **in that** said at least one predetermined threshold value comprises a voltage value associated with said module.

9. Device according to one of claims 5 to 8, **characterised in that** said at least one parameter provided by a measuring card (260) of a module is representative of an electrical current signal consumed by said module, and **in that** said at least one predetermined threshold value comprises an electrical current value associated with said module.

10. Device according to one of claims 5 to 9, **characterised in that** said at least one parameter provided by a measuring card (260) of a module is representative of a temperature signal of said module, and **in that** said at least one predetermined threshold value comprises a temperature value associated with said module.

11. Device according to one of claims 5 to 10, **characterised in that** said at least one parameter provided by a measuring card (260) of a module is representative of an instantaneous dose signal of ionising radiation undergone by said module and/or a cumulative dose signal of ionising radiation undergone by said module, and **in that** said at least one predetermined threshold value comprises an instantaneous dose value and/or a cumulative dose value respectively associated with said module.

12. Device according to one of claims 5 to 11, **characterised in that** said at least one signal provided by a measuring card (260) of a module is measured periodically according to a predetermined period, preferably a period substantially equal to 1 second.

13. Device according to one of claims 2 to 12, **characterised in that** the monitoring module (220) is adapted to detect a power failure of said device (200), and **in that** it includes storage means adapted to save the electronic configuration of said device (200) during the activation of one of said electronic apparatuses of the function module (210) and/or during a power failure of said device (200).

14. Device according to claim 13, **characterised in that** said storage means include an electronic chip (270) of the EEPROM type.

15. Device according to one of claims 2 to 14, **characterised in that** the power module (240) includes voltage regulators adapted to provide regulated power voltages respectively to the monitoring module (220) and to the function module (210).

16. Device according to claim 2 to 15, **characterised in that** the energy source of the power module (240) is external to said device, and delivers an alternating voltage or else a direct voltage.

17. Device according to claim 2 to 15, **characterised in that** the energy source of the power module (240) comprises an electric battery (241) integrated with said device and delivering a direct voltage.

18. Device according to one of claims 2 to 17, **characterised in that** the function provided by the electronic apparatuses of the function module (210) is a communication function on a wireless communication network according to a predetermined protocol, each communication apparatus including a communication card (212) adapted to convey signals according to said protocol as well as an omnidirectional (213) or even directive antenna according to the use for which the device (200) is intended.

19. System (300) intended to operate in a hostile environment (500) **characterised in that** it includes:
- a first device (301) according to one of claims 2 to 18, intended to be connected by means of the connection terminal of the function module (210) thereof to a mobile apparatus (519), for example a nuclear dismantling robot, equipped with said first device (301),
- a second device (302) according to one of claims 2 to 18, intended to be connected by means of the connection terminal of the function module (210) thereof to a remote terminal (700) installed outside the hostile environment (500),
- a set of software-configured means to forcibly configure and control the respective operations of said first (301) and second (302) devices, as well as to iteratively monitor the integrity of said first (301) and second (302) devices, and further intended to forcibly control the displacements of said mobile apparatus (519).

20. System according to claim 19, **characterised in that** said set of software-configured means is a computer program product including a set of program code instructions intended to be executed by said remote terminal (700), preferably a desktop PC including at least one processor.

21. Method for extending the service life of a function of a device (200) according to one of claims 1 to 18, said method including a preliminary step (1000) of characterising the integrity of said device so as to obtain said at least one threshold value, said device being deactivated at the end of said preliminary step (1000), said method further being **characterised in that** it includes the following successive steps:
- a step (2000) of initialising the device in which the routing of the electronic apparatuses of said device is defined,
- a step (3000) of starting the device in which a single electronic apparatus is activated, the other electronic apparatuses remaining deactivated,
- a step (4000) of measuring at least one operating parameter of the activated electronic apparatus,
- a step (5000) of analysing the integrity of the device in which, when the integrity of the function module of said device is altered, the activated electronic apparatus is permanently deactivated, and only one of said other deactivated electronic apparatuses is activated, or else the activated electronic apparatus remains activated, and said other deactivated electronic apparatuses remain deactivated,
- a step (6000) of evaluating a remaining service life of the device by the monitoring module of said device,
the measurement (4000), analysis (5000) and evaluation (6000) steps being iteratively executed until the remaining service life of a previously activated then deactivated electronic apparatus is restored, or the remaining service life of the device (200) is exhausted.
